(19) **Europäisches Patentamt European Patent Office Office européen des brevets**

(11) **EP 4 526 915 B1**

(12) **EUROPEAN PATENT SPECIFICATION**

(45) Date of publication and mention
of the grant of the patent:
**06.08.2025 Bulletin 2025/32**

(21) Application number: **23768319.8**

(22) Date of filing: **15.09.2023**

(51) International Patent Classification (IPC):
**H01J 37/04** *(2006.01)* **H01J 37/073** *(2006.01)*

(52) Cooperative Patent Classification (CPC):
**H01J 37/073; H01J 37/045;** H01J 2237/06333;
H01J 2237/065; H01J 2237/24485; H01J 2237/2802

(86) International application number:
**PCT/EP2023/075496**

(87) International publication number:
**WO 2024/061773 (28.03.2024 Gazette 2024/13)**

(54) **ELECTRON BEAM APPARATUS AND METHOD FOR GENERATING A PULSED ELECTRON BEAM AND APPLICATIONS THEREOF**

ELEKTRONENSTRAHLVORRICHTUNG UND VERFAHREN ZUR ERZEUGUNG EINES GEPULSTEN ELEKTRONENSTRAHLS UND ANWENDUNGEN DAVON

APPAREIL À FAISCEAU D'ÉLECTRONS ET PROCÉDÉ DE GÉNÉRATION D'UN FAISCEAU D'ÉLECTRONS PULSÉ ET SES APPLICATIONS

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **23.09.2022 EP 22197542**

(43) Date of publication of application:
**26.03.2025 Bulletin 2025/13**

(73) Proprietor: **Max-Planck-Gesellschaft zur Förderung der Wissenschaften e.V. 80539 München (DE)**

(72) Inventors:
• **FEIST, Armin**
**37077 Göttingen (DE)**
• **ROPERS, Claus**
**37077 Göttingen (DE)**
• **HAINDL, Rudolf**
**37077 Göttingen (DE)**

(74) Representative: **v. Bezold & Partner Patentanwälte - PartG mbB Ridlerstraße 57 80339 München (DE)**

(56) References cited:
• **KERAMATI SAM ET AL: "Non-Poissonian Ultrashort Nanoscale Electron Pulses",** PHYSICAL REVIEW LETTERS, vol. 127, no. 18, 27 October 2021 (2021-10-27), US, XP093105072, ISSN: 0031-9007, Retrieved from the Internet <URL:https://journals.aps.org/prl/pdf/10.1103/PhysRevLett.127.180602> DOI: 10.1103/PhysRevLett.127.180602
• **SAM KERAMATI: "Partial Quantum Coherence, Ultrashort Electron Pulse Statistics, and a Plasmon-Enhanced Nanotip Emitter Based on Metallized Optical Fibers",** ARXIV.ORG, CORNELL UNIVERSITY LIBRARY, 201 OLIN LIBRARY CORNELL UNIVERSITY ITHACA, NY 14853, 25 January 2021 (2021-01-25), XP081866631
• **BECKER WILHELM ET AL: "Theories of photoelectron correlation in laser-driven multiple atomic ionization",** REVIEWS OF MODERN PHYSICS, vol. 84, no. 3, 1 July 2012 (2012-07-01), pages 1011 - 1043, XP093104556, ISSN: 0034-6861, DOI: 10.1103/RevModPhys.84.1011

## Description

Field of the invention

The present invention relates to an electron beam apparatus and/or method for generating a pulsed electron beam, comprising a sequence of electron pulses. Applications of the invention are available e. g. in the fields of electron microscopy or material processing with electron lithography.

Background of the invention

In the present specification, reference is made to the following prior art illustrating technical background of the invention and related techniques:

[1] D. N. Klyshko, Phys.-Usp. 39, 573 (1996);

[2] M. I. Kolobov, Rev. Mod. Phys. 71, 1539 (1999);

[3] G. Kotliar and D. Vollhardt, Physics Today 57, 53 (2004);

[4] E. Morosan, D. Natelson, A. H. Nevidomskyy, and Q. Si, Adv. Mater. 24, 4896 (2012);

[5] T. D. Ladd, F. Jelezko, R. Laflamme, Y. Nakamura, C. Monroe, and J. L. O'Brien, Nature 464, 45 (2010);

[6] O. Kfir, V. Di Giulio, F. J. G. de Abajo, and C. Ropers, Sci. Adv. 7, eabf6380 (2021);

[7] S. Asban and F. J. Garcia de Abajo, npj Quantum Inf 7, 42 (2021);

[8] V. Di Giulio, M. Kociak, and F. J. G. de Abajo, Optica 6, 1524 (2019), arXiv:1905.06887;

[9] A. E. Turner, C. W. Johnson, P. Kruit, and B. J. McMorran, Phys. Rev. Lett. 127, 110401 (2021);

[10] P. Kruit, R. Hobbs, C.-S. Kim, Y. Yang, V. Manfrinato, J. Hammer, S. Thomas, P. Weber, B. Klopfer, C. Kohstall, T. Juffmann, M. Kasevich, P. Hommelhoff, and K. Berggren, Ultramicroscopy 164, 31 (2016);

[11] T. Juffmann, S. A. Koppell, B. B. Klopfer, C. Ophus, R. M. Glaeser, and M. A. Kasevich, Sci. Rep. 7, 1699 (2017), arXiv:1612.04931;

[12] E. Rotunno, S. Gargiulo, G. M. Vanacore, C. Mechel, A. Tavabi, R. E. D. Borkowski, F. Carbone, I. Maidan, M. Zanfrognini, S. Frabboni, T. Guner, E. Karimi, I. Kaminer, and V. Grillo, arXiv:2106.08955 (2021), arXiv:2106.08955;

[13] O. Kfir, Phys. Rev. Lett. 123, 103602 (2019);

[14] V. Di Giulio, O. Kfir, C. Ropers, and F. J. Garcia de Abajo, ACS Nano 15, 7290 (2021);

[15] A. Feist, G. Huang, G. Arend, Y. Yang, J.-W. Henke, A. S. Raja, F. J. Kappert, R. N. Wang, H. Lourenço-Martins, Z. Qiu, J. Liu, O. Kfir, T. J. Kippenberg, and C. Ropers, Science 377, 777 (2022);

[16] M. Leijnse, M. R.Wegewijs, and M. H. Hettler, Phys. Rev. Lett. 103, 156803 (2009);

[17] B. Hensen, H. Bernien, A. E. Dréau, A. Reiserer, N. Kalb, M. S. Blok, J. Ruitenberg, R. F. L. Vermeulen, R. N. Schouten, C. Abellán, W. Amaya, V. Pruneri, M. W. Mitchell, M. Markham, D. J. Twitchen, D. Elkouss, S. Wehner, T. H. Taminiau, and R. Hanson, Nature 526, 682 (2015);

[18] A. Konecná, F. Iyikanat, and F. J. G. de Abajo, ArXiv220200604 Quant-Ph (2022), arXiv:2202.00604 [quant-ph];

[19] H. Kiesel, A. Renz, and F. Hasselbach, Nature 418, 392 (2002);

[20] M. Muñoz-Navia, C. Winkler, R. Patel, M. Birke, F. O. Schumann, and J. Kirschner, J. Phys.: Condens. Matter 21, 355003 (2009);

[21] A. Trützschler, M. Huth, C.-T. Chiang, R. Kamrla, F. O. Schumann, J. Kirschner, and W. Widdra, Phys. Rev. Lett. 118, 136401 (2017);

[22] S. Larochelle, A. Talebpour, and S. L. Chin, J. Phys. B: At. Mol. Opt. Phys. 31, 1201 (1998);

[23] W. Becker, X. Liu, P. J. Ho, and J. H. Eberly, Rev. Mod. Phys. 84, 1011 (2012);

[24] M. Kuwahara, Y. Yoshida, W. Nagata, K. Nakakura, M. Furui, T. Ishida, K. Saitoh, T. Ujihara, and N. Tanaka, Phys. Rev. Lett. 126, 125501 (2021);

[25] S. Keramati,W. Brunner, T. J. Gay, and H. Batelaan, Phys. Rev. Lett. 127, 180602 (2021);

[26] T. Kodama and N. Osakabe, Microscopy 68, 133 (2019);

[27] H. Boersch, Z. Physik 139, 115 (1954);

[28] M. Kuwahara, Y. Nambo, K. Aoki, K. Sameshima, X. Jin, T. Ujihara, H. Asano, K. Saitoh, Y. Takeda, and N. Tanaka, Appl. Phys. Lett. 109, 013108 (2016);

[29] K. Loeffler, Z. Angew. Phys. 27, 145 (1969);

[30] G. Jansen, Nuclear Instruments and Methods in Physics Research Section A: Accelerators, Spectrometers, Detectors and Associated Equipment 298, 496 (1990);

[31] N. Bach, T. Domröse, A. Feist, T. Rittmann, S. Strauch, C. Ropers, and S. Schäfer, Struct. Dyn. 6, 014301 (2019);

[32] P. Emma, Z. Huang, K.-J. Kim, and P. Piot, Phys. Rev. ST Accel. Beams 9, 100702 (2006);

[33] R. Dörner, V. Mergel, O. Jagutzki, L. Spielberger, J. Ullrich, R. Moshammer, and H. Schmidt-Böcking, Physics Reports 330, 95 (2000);

[34] J. Ullrich, R. Moshammer, A. Dorn, R. Dörner, L. P. H. Schmidt, and H. Schmidt-Böcking, Rep. Prog. Phys. 66, 1463 (2003);

[35] G. van Riessen, Z. Wei, R. S. Dhaka, C. Winkler, F. O. Schumann, and J. Kirschner, J. Phys.: Condens. Matter 22, 092201 (2010);

[36] T. Danz, T. Domröse, and C. Ropers, Science 371, 371 (2021);

[37] N. Rubiano da Silva, M. Möller, A. Feist, H. Ulrichs, C. Ropers, and S. Schäfer, Phys. Rev. X 8, 031052 (2018);

[38] A. Feist, N. Rubiano da Silva, W. Liang, C. Ropers, and S. Schäfer, Struct. Dyn. 5, 014302 (2018);

[39] N. Bach, A. Feist, M. Möller, C. Ropers, and S. Schäfer, Struct. Dyn. 10.1063/4.0000144 (2022);

[40] T. R. Harvey, J.-W. Henke, O. Kfir, H. Lourengo-Martins, A. Feist, F. J. Garcia de Abajo, and C. Ropers, Nano Lett. 20 4377 (2020);

[41] O. Kfir, H. Lourengo-Martins, G. Storeck, M. Sivis, T. R. Harvey, T. J. Kippenberg, A. Feist, and C. Ropers, Nature 582, 46 (2020);

[42] J.-W. Henke, A. S. Raja, A. Feist, G. Huang, G. Arend, Y. Yang, F. J. Kappert, R. N. Wang, M. Möller, J. Pan, J. Liu, O. Kfir, C. Ropers, and T. J. Kippenberg, Nature 600, 653 (2021);

[43] M. Liebtrau, M. Sivis, A. Feist, H. Lourengo-Martins, N. Pazos-Pérez, R. A. Alvarez-Puebla, F. J. Garcia de Abajo, A. Polman, and C. Ropers, Light Sci Appl 10, 82 (2021);arXiv:2008.10527;

[44] D. Jannis, C. Hofer, C. Gao, X. Xie, A. Béché, T. Pennycook, and J. Verbeeck, Ultramicroscopy 233, 113423 (2022);

[45] Y. Auad, M.Walls, J.-D. Blazit, O. Stéphan, L. H. Tizei, M. Kociak, F. De la Peña, and M. Tencé, Ultramicroscopy, 113539 (2022);

[46] D. Jannis, K. Müller-Caspary, A. Béché, A. Oelsner, and J. Verbeeck, Appl. Phys. Lett. 114, 143101 (2019);

[47] N. Varkentina, Y. Auad, S. Y. Woo, A. Zobelli, J.-D. Blazit, X. Li, M. Tencé, K. Watanabe, T. Taniguchi, O. Stéphan, M. Kociak, and L. H. G. Tizei, arXiv:2202.12520 (2022) arXiv:2202.12520;

[48] A. Feist, N. Bach, N. Rubiano da Silva, T. Danz, M. Möller, K. E. Priebe, T. Domröse, J. G. Gatzmann, S. Rost, J. Schauss, S. Strauch, R. Bormann, M. Sivis, S. Schäfer, and C. Ropers, Ultramicroscopy 176, 63 (2017);

[49] B. Cook, M. Bronsgeest, K. Hagen, and P. Kruit, Ultramicroscopy 109, 403 (2009);

[50] J. Schötz, L. Seiffert, A. Maliakkal, J. Blöchl, D. Zimin, P. Rosenberger, B. Bergues, P. Hommelhoff, F. Krausz, T. Fennel, and M. F. Kling, Nanophotonics 10, 3769 (2021);

[51] M. Bronsgeest, Physics of Schottky Electron Sources: Theory and Optimum Operation (Pan Stanford Publications, Singapore, 2014);

[52] T. Kodama, N. Osakabe, and A. Tonomura, Phys. Rev. A 83, 063616 (2011);

[53] G. Baym and K. Shen, ArXiv12124008 Cond-Mat Physicsquant-Ph (2012), arXiv:1212.4008 [cond-mat, physics:quant-ph];

[54] D. N. Fittinghoff, P. R. Bolton, B. Chang, and K. C. Kulander, Phys. Rev. Lett. 69, 2642 (1992);

[55] R. Herrmann, S. Samarin, H. Schwabe, and J. Kirschner, Phys. Rev. Lett. 81, 2148 (1998);

[56] S. A. Sheinerman and V. Schmidt, J. Phys. B: At. Mol. Opt. Phys. 30, 1677 (1997);

[57] S. Meier and P. Hommelhoff, ACS Photonics, acsphotonics. 2c00839 (2022);

[58] O. L. Krivanek, J. P. Ursin, N. J. Bacon, G. J. Corbin, N. Dellby, P. Hrncirik, M. F. Murfitt, C. S. Own, and Z. S. Szilagyi, Phil. Trans. R. Soc. A. 367, 3683 (2009);

[59] van Schayck, J. Paul, M4I-nanoscopy/tpx3Hit-Parser: Create-cluster_stats option for storing sum-ToT and nHits, Zenodo (2021);

[60] J. P. van Schayck, E. van Genderen, E. Maddox, L. Roussel, H. Boulanger, E. Fröjdh, J.-P. Abrahams, P. J. Peters, and R. B. Ravelli, Ultramicroscopy 218, 113091 (2020);

[61] R. F. Egerton "Electron energy-loss spectroscopy in the TEM" in "Reports on Progress in Physics" 72, (2009).;

[62] O. L. Krivanek, A. J. Gubbens, N. Dellby, C. E. Meyer, Design and first applications of a post-column imaging filter. Microscopy Microanalysis Microstructures. 3, 187-199 (1992);

[63] F. Kahl, V. Gerheim, M. Linck, M. Heiko, S. Uhlemann, H. Müller, R. Schillinger, S. Uhlemann, "Test and characterization of a new post-column imaging energy filter" in Advances in Imaging and Electron Physics (Elsevier Inc., 2019; https://doi.org/10.1016/bs.aiep.2019.08.005), vol. 212, pp. 35-70; and

[64] K. Kimoto, Practical aspects of monochromators developed for transmission electron microscopy. Microscopy (Tokyo). 63, 337-344 (2014).

The control of quantum statistics of fermionic and bosonic modes is at the heart of non-classical light sources [1, 2] and strongly correlated functional materials ([3, 4]), and enables (noise-corrected) quantum computers [5]). Developing these concepts in the context of free-electron quantum optics promises quantum coherent manipulation [6, 7], sensing [8] and imaging at the nanoscale, with new opportunities arising from structural biology and material science to electron beam lithography. In particular, recent theoretical and experimental work explored quantum-enhanced electron microscopy, relying on interferometric [9] or multipass schemes [10, 11], emission of quantum light [12], or tailored interactions with optical modes [6, 8, 13-15].

While correlated multi-electron states are ubiquitous in experimental condensed matter physics [16, 17], their analogue in free particle beams was not yet observed, but proposed mechanisms include indirect coupling at long-lived optical modes [13, 18], common path interference [19], or correlated photo-emission [20, 21] and ionization [22, 23] processes. As a hallmark of entanglement, and necessary condition, particle correlations in free-electron beams were studied in transverse [19, 24] and longitudinal [25] phase space, considering contributions from exchange-mediated [24] or Coulomb [26] interaction. In particular, classical Coulomb repulsion leads to stochastic transverse and longitudinal emittance growth in electron beams, described by the Boersch [27, 28] and Loeffler [29] effect, respectively, limiting the brightness of state-of-the-art electron sources [30]. In high-charge electron pulses, mean-field induced space charge effects govern the achievable pulse duration, energy spread and focusability [31], and pose a major experimental challenge in ultrafast electron microscopy and diffraction, particle accelerators and free-electron lasers [32].

Coincidence spectroscopy is well established in atomic and molecular science [33, 34], and has revealed intricate collision mechanisms and correlation effects in solids [20, 35], COLTRIMS, reaction microscope, and other correlation detection techniques.

Miniaturizing the electron source to generate coherent electron pulses at nanoscale tip-shaped emitters, enabling ultrafast dark-field [36] or phase-contrast imaging [37], nanoscale diffractive probing [38, 39], and photon-induced near-field electron microscopy [40-43], requires in-depth analysis of stochastic Coulomb and mean-field effects even for low-charge electron bunches [31].

However, disentangling both contributions requires single-particle-resolved event-based detection, which was only recently introduced in electron microscopes, applied for high-speed STEM [44, 45] and EELS [42], and detecting electron-correlated X-ray emission [46], and cathodoluminescence at quantum materials [47] and integrated photonic resonators [15].

Objective of the invention

The objective of the invention is to provide an improved electron beam apparatus and/or method for generating a pulsed electron beam, which is capable of avoiding limitations of conventional techniques for generating electron beams. In particular, a pulsed electron beam is to be generated with a tailored pulse statistic, thus in particular allowing an extended range of new applications, like electron microscopy applications with reduced noise and/or improved imaging quality, and/or improved applications in electron lithography and/or quantum computing, and/or new applications in electron manipulation.

Summary of the invention

These objectives are solved with an electron beam apparatus and/or method for generating a pulsed electron beam, comprising the features of the independent claims, respectively. Advantageous embodiments and applications of the invention are defined in the dependent claims.

According to a first general aspect of the invention, the above objective is solved by an electron beam apparatus, configured for generating a pulsed electron beam, comprising a sequence of electron pulses, comprising a radiation source device being arranged for creating a sequence of emitter excitation pulses, in particular laser pulses, an electron source device having a photoemission electron source, which is arranged for radiation-induced emission of source electron pulses in response to an irradiation with the emitter excitation pulses, a number state dispersion device being arranged for spatially separating the source electron pulses into sub-pulses, wherein each sub-pulse includes an integer electron number (n), with n = 1, 2, 3, ..., and a number state selector device being arranged for selecting sub-pulses comprising at least one set of predetermined electron number states as the pulsed electron beam to be created.

According to a second general aspect of the invention, the above objective is solved by a method of generating a pulsed electron beam, comprising a sequence of electron pulses, comprising the steps of creating a sequence of emitter excitation pulses, in particular laser pulses, with a radiation source device, irradiating a photoemission electron source of an electron source device with the emitter excitation pulses, so that source electron pulses are created by radiation-induced emission, spatially separating the source electron pulses into sub-pulses, wherein each sub-pulse includes an integer electron number (n), with n = 1, 2, 3, ..., with a number state dispersion device, and selecting sub-pulses comprising at least one set of predetermined electron number states as the pulsed electron beam to be generated, with a number state selector device. Preferably, the method of the second general aspect of the invention or an embodiment thereof is executed with the electron beam apparatus according to the first general aspect or an embodiment thereof. All preferred embodiments disclosed here with reference to the apparatus are considered as corresponding preferred embodiments of the method and vice versa.

According to a third general aspect of the invention, the above objective is solved by a method of using the electron beam apparatus according to the first general aspect or an embodiment thereof as a beam source in at least one of an electron microscopy apparatus, an electron lithography apparatus, an electron pairs (source) apparatus, an electron heralding apparatus, an electron counting apparatus (application wherein an exact number of electrons is determined), an information processing apparatus, a communication apparatus, and a quantum computing apparatus. The electron microscopy apparatus, the electron lithography apparatus, and/or a quantum computing apparatus, provided with the electron beam apparatus according to the first general aspect or an embodiment thereof and/or configured for executing the method of the second general aspect of the invention or an embodiment thereof are considered as independent subjects of the present invention.

The term "pulse" used here generally refers to a waveform providing a predetermined, non-continuous time structure of the source electrons. The pulses may be provided as a periodic pulse sequence. Selecting sub-pulses comprising at least one set of predetermined electron number states includes selecting a single set of sub-pulses with a single electron number state, like, e.g., n = 2, or selecting multiple sets of sub-pulses, each with another electron number state, like, e.g., n>1, n=1, or the like. Accordingly, in the case of selecting multiple sets of sub-pulses, different electron number states can be combined.

The number state dispersion device spatially separates the pulses in integer electron numbers n = 0, 1, 2, 3, ..., and projects the electron beam onto the number state selector device. The number-state selector device comprises e. g. an aperture, a slit, and/or a beam block for blocking/rejecting a subset of the quantized number states n = 0, 1, 2, 3, ....

The inventors have observed Coulomb-correlated electron pair and triplet states generated by femtosecond pulsed photoemission from a nanoscale tip emitter inside an ultrafast transmission electron microscope. Event-based electron spectroscopy enables unambiguous identification of specific number states by their characteristic inter-particle few-electronvolt kinetic energy separation. State-sorted beam caustics show an increased virtual source size for higher electron numbers induced by stochastic Coulomb scattering, and the energetic state separation is imprinted in the averaged spectra. The inventors propose a scheme where simple filtering of the beam, like e. g. spectral filtering, spatial filtering and/or spin filtering, enables a state selection and tailoring of the pulse statistics. Furthermore, adopting the electrostatic emitter configuration may change the electron kinetic energy separation and relative occurrence of desired number states, optimized for specific applications. This will allow advanced control schemes, e.g., for the generation of sub-Poissonian electron beams or implementation of heralded single-electron sources, that may lift limitations in aberration correction of electron microscopes and shot-noise in electron beam lithography.

According to a preferred embodiment of the invention, the photoemission electron source is configured for generating countable low-charge electron pulses, preferably including 1, 2, 3 or 4 electrons per pulse.

According to a preferred embodiment of the invention, the photoemission electron source comprises a beam-limiting aperture configured for reducing high-charge electron pulses to countable low-charge electron pulses. The beam-limiting aperture may be arranged just downstream from the electron source device and upstream of an optional accelerator and condenser optics.

According to a preferred embodiment of the invention, the photoemission electron source is configured for generating multi-electron states with distinguishable properties in addition to the pulse charge.

According to a preferred embodiment of the invention, the number state dispersion device comprises an energy-dispersive device, like e. g. a spectrometer device. The spectrometer device may be arranged for spectrally decomposing the source electron pulses and applying an energy filter to the source electron pulses. The spatial filter device may be arranged in an energy-selective plane of the spectrometer device. A second spectrometer device may be provided for merging the selected subset of electrons into a common beam.

According to a preferred embodiment of the invention, the energy-dispersive device may comprise a beam monochromator, in particular a beam monochromator of the omega-type, alpha-type, Wien-Filter-type, Double-Wien-type, electron-mirror type, or other types of monochromators, and/or a spectrometer device being configured for separating spectral components of the source electron pulses, in particular a spectrometer device comprising a magnetic prism, a spectrometer device comprising an electrostatic multipole electron optics, or other types of spectrometers.

According to a preferred embodiment of the invention, the number state dispersion device comprises a spatial dispersion device, in particular, at least one of a rotation-symmetric electron lens and a cylindrical electron lens. The spatial dispersion device may be designated as an (electron) momentum dispersion device, a position dispersion device, an electron orbital momentum dispersion device, or an electron spin dispersion device.

According to a preferred embodiment of the invention, the number state selector device comprises a spatial modulator of the electron beam intensity, in particular being configured for passing the selected sub-pulses with the predetermined electron number state and blocking the remaining sub-pulses.

According to a preferred embodiment of the invention, the number state selector device comprises at least one of a mechanical slit, grating, linear beam block, hole, ring, or disk. The selector device is preferably made of an electrically conducting material or as an electrode, being adapted for absorbing, preferably fully absorbing the electron number states to be rejected.

According to a preferred embodiment of the invention, the electron beam apparatus further comprises at least one of a detector device being configured for determining a number of electrons within at least one of the electron number states of the pulsed electron beam, and a beam-forming electron optics being configured for illuminating a sample, like a sample to be investigated and/or a workpiece, like a semiconductor workpiece.

According to a preferred embodiment of the invention, the photoemission electron source comprises a tip-shaped photoemission electron source, preferably configured for linear photoemission, in particular at least one of a Schottky-type emitter, a cold-field-type emitter, and a thermionic emitter.

The photoemission electron source may comprise a tungsten tip having a (100) crystal facet covered by a zirconium-oxide thin film, or a composite tip made from a material having an electron work function equal to or below the electron work function of Lanthanum Hexaboride, $LaB_6$, or Cerium Hexaboride, $CeB_6$, or a metal tip with a crystal tip facet having a reduced electron work function compared with the remaining tip material, or a pure metal tip, in particular being made of W, Mo, Re, Ir, Ta, Hc, Pt, or Ni, or a transition metal carbide tip, in particular being made of HfC, ZrC, NbC, TaC, TiC, or VC, or carbon-cone emitter or a single carbon nanotube tip.

The radiation source device may comprise a laser source, and/or the radiation source device may be configured for creating the emitter excitation radiation with a wavelength selected in dependency on the application conditions, in particular the emitter tip material, e.g., in at least one of a range from 1 nm to 200 nm, a range from 200 nm to 1500 nm, and a range from 1500 nm to 16 $\mu$m.

According to preferred embodiments of the inventive method, at least one of the following steps may be provided

- adjusting the radiation source device and/or the photoemission electron source for generating multi-electron states, that are distinguishable by a property besides the pulse charge (=number of electrons),
- adjusting the number state dispersion device according to a distinguishable property of the source electron pulses, in particular an energy, angle/momentum, spatial focus,
- adjusting the number state-selector device for rejecting or blocking specific number states from the beam, in particular interesting for rejecting or blocking all n>2 or for rejecting or blocking all sub-pulses with n $\neq$ 2, and
- adjusting the radiation source device, the photoemission electron source, the number state dispersion device and/or the number state selector device based on an output of an additional number-state sensitive detector.

Brief description of the drawings

Further details and advantages of the invention are described in the following with reference to the attached drawings, which schematically show in:

Figures 1 to 8:      illustrations of features of preferred embodiments of the invention; and

Figure 9 to 13:      illustrations of further features of preferred embodiments and experimental tests of the invention.

Description of preferred embodiments

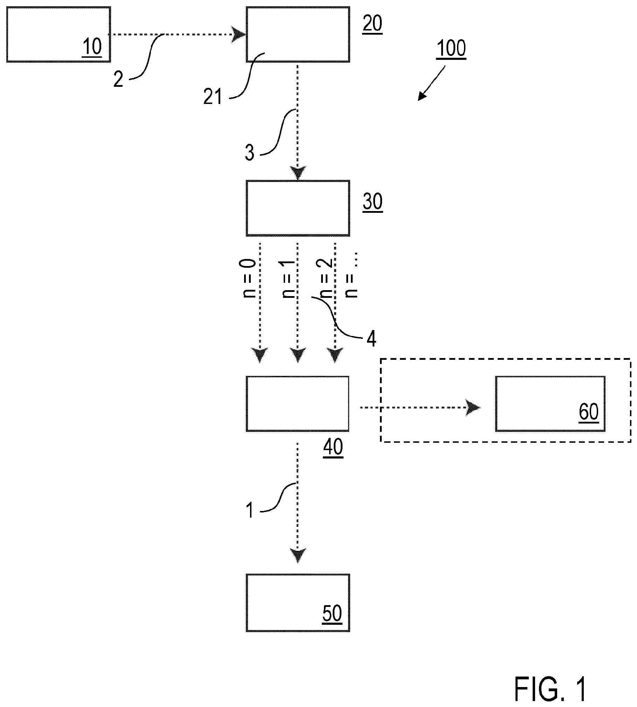

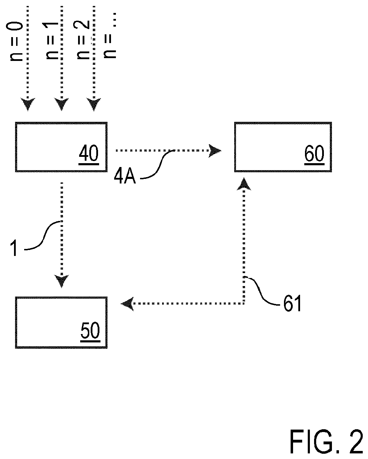

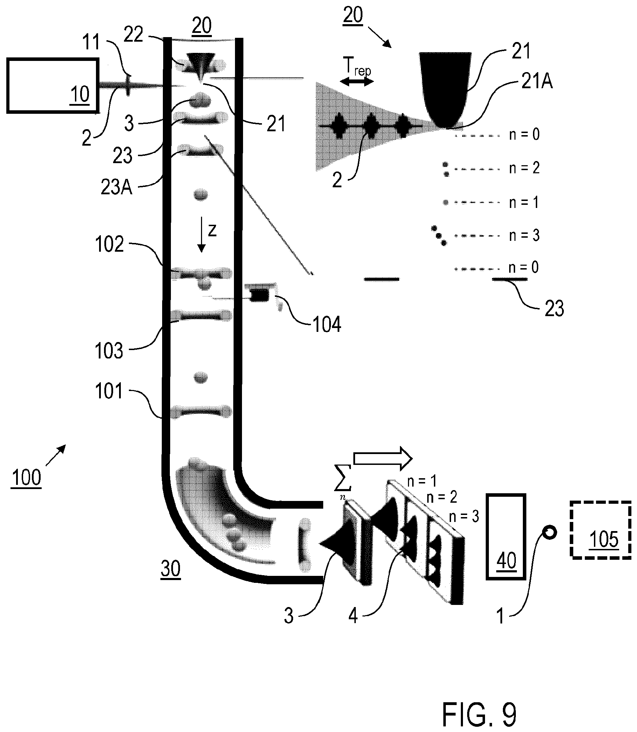

Figures 1 to 8 schematically illustrate the general principle of the invention (in particular Figure 1) and features of preferred embodiments for implementing the invention in practice (in particular Figures 2 to 8). Further details of the practical implementation, as based on experimental findings of the inventors, are described with reference to Figures 9 to 13.

The embodiments of the invention are described with particular reference to preparing and/or analyzing a pulsed electron beam with a well-defined number or charge state. The electron beam apparatus may be implemented based on a transmission electron microscope as outlined below. Details and/or operation parameters of the transmission electron microscope, like adjusting an acceleration voltage, and/or the laser source for exciting the electron source of the transmission electron microscope, like controlling power of the laser source, are not described as far as they are known per se from conventional electron microscopy techniques.

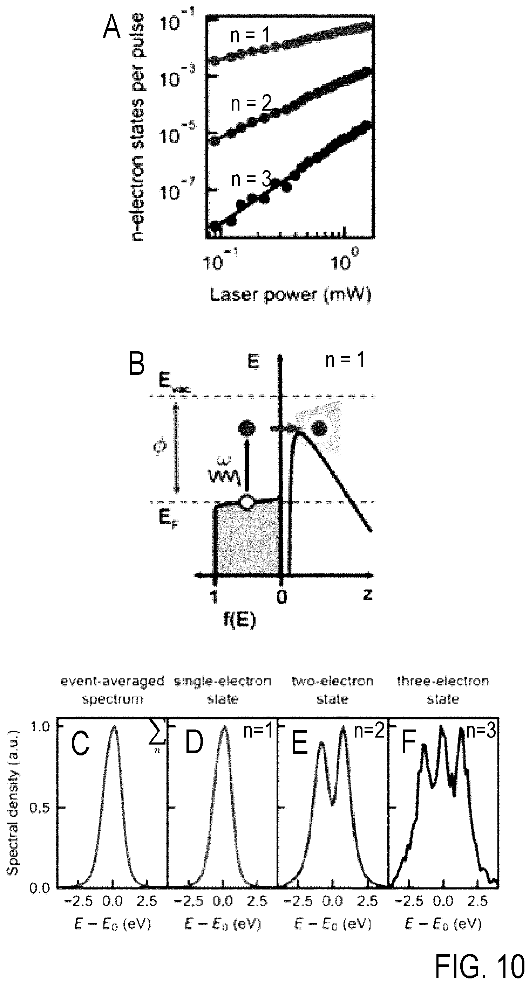

Implementing of the invention is not restricted to the electron microscope application, but rather possible with other applications as mentioned above. Furthermore, the invention is not restricted to the application conditions provided for the practical tests illustrated in Figures 10 to 14. Depending on the application, embodiments of the invention may be modified, e.g., with regard to the design of the number state dispersion device and/or the number state selector device.

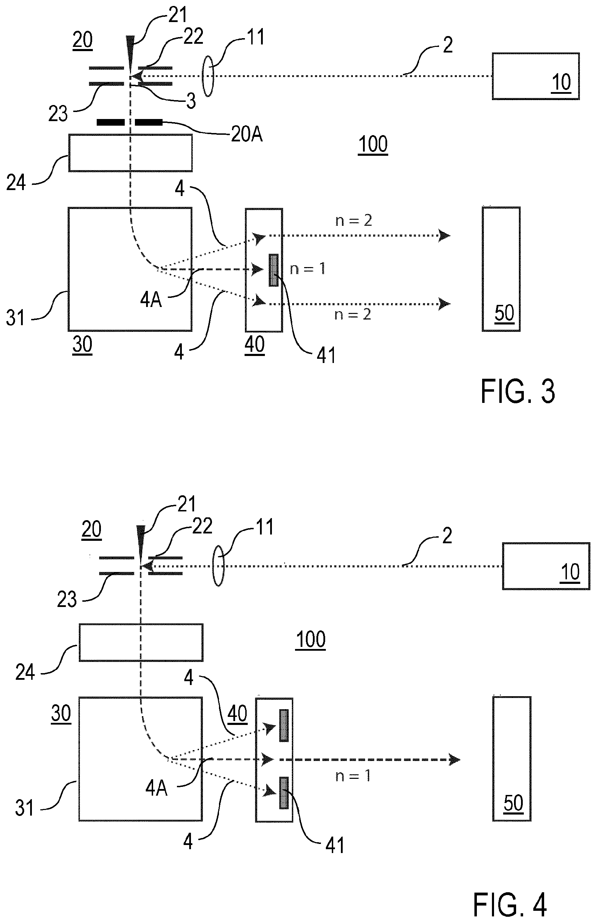

Figure 1 schematically shows an electron beam apparatus 100 for generating a pulsed electron beam 1, comprising a sequence of electron pulses. The electron beam apparatus 100 comprises a radiation source device 10, in particular a pulsed radiation source, like a pulse laser, being arranged for creating a sequence of emitter excitation pulses 2, in particular a pulsed laser beam of laser pulses. The electron beam apparatus 100 further comprises an electron source device 20 having a photoemission electron source 21. Exemplary details of the photoemission electron source 21 are shown in particular in Figures 3 to 9.

The photoemission electron source 21 is arranged for receiving the emitter excitation pulses 2 and for radiation-induced emission of source electron pulses 3 in response to the irradiation with the emitter excitation pulses 2 directed onto the photoemission electron source 21. The source electron pulses 3 provide a pulsed electron beam with few (countable) electrons per pulse. In particular, each source electron pulse 3 includes a number n of, e.g., 1, 2, 3 or more electrons. The pulse charge of each source electron pulse 3 is correspondingly determined by the number of electrons per pulse. Besides the pulse charge/electron number, the multi-electron state (number-state) of the source electron pulses 3 is distinguishable by at least one physical property, like e.g., an energy, angle/momentum, position, spin and/or spatial defocus of the electrons resulting after the number-state dispersion device and being determined by an angle/transverse momentum of the source electron pulses.

The source electron pulses 3 are directed along an optical axis z (electron beam axis z) to a number state dispersion device 30 of the electron beam apparatus 100. The number state dispersion device 30 is arranged for spatially separating the sequence of source electron pulses 3 into separated sub-sequences of source electron pulses 4, wherein each sub-sequence includes source electron pulses 4 with a common integer electron number (n), with n = 1, 2, 3, .... The number state dispersion device 30 provides a dispersion along at least one distinguishable physical property. Accordingly, the number states are dispersed in one or multiple parts. In dependency on the physical property of the number state, each source electron pulse 3 is directed onto a different one of the pulse paths of the sub-pulses 4 (see Figures 3 to 9).

Furthermore, the electron beam apparatus 100 comprises a number state selector device 40 being arranged for receiving the spatially separated sub-pulses 4 and for selecting one of the sub-pulses 4 comprising at least one set of a predetermined electron number state as the pulsed electron beam 1 to be generated. Based on the at least one distinguishable physical property, pulses with a specific number state are transmitted by the number state selector device 40 as the pulsed electron beam 1, while pulses with number states other than the specific number state are rejected, in particular blocked, or optionally split by the number state selector device 40, as shown in exemplary manner in particular in Figures 3 to 9.

The pulsed electron beam 1 is directed to a sample and/or application site 50 accommodating e.g., a sample to be investigated with the pulsed electron beam 1 or a workpiece to be processed with the pulsed electron beam 1. At the sample and/or application site 50, only specific number states are used, e.g. with n < 2 or n = 2. The sample and/or application site 50 includes e.g., a sample stage of a microscopy apparatus, a spectroscopy apparatus or a lithography apparatus. For example, only sub-sequences of source electron pulses 4 with 2 electrons per pulse are used for investigating a sample by electron microscopy or for irradiating a workpiece.

Optionally, a number state reporting channel 60 can be provided, including an electron pulse detector device. With the number state reporting channel 60, one channel of the number state n can be detected, while the state n-1 is used at the sample and/or application site 50, e.g. realizing a heralded single electron source.

Further details of the optional application with heralding of specific number states are illustrated in Figure 2, including the number state selector device 40, the sample and/or application site 50 and the number state reporting channel 60, as shown in Figure 1. With the number state selector device 40, the pulsed electron beam 1 with the state m = n-1 is transmitted to the sample and/or application site 50 and non-selected source electron pulses 4A with the state n are split to the number state reporting channel 60. The non-selected sub-sequences of source electron pulses 4A comprise e.g., single electron pulses detected with the detector device, which is included in the number state reporting channel 60.

The number state reporting channel 60 may be coupled with the sample and/or application site 50 via an information channel 61. For example, a precisely countable number of electrons may be submitted to the number state reporting channel 60 and the sample or to the number state reporting channel 60 and the application site 50. Thereby, knowledge about the precise number of electrons in the electron state transmitted to the sample and/or application site 50 is obtained, relevant, e.g., for microscopy and lithography applications with well-defined electron dose.

Further details of an electron beam apparatus 100, e.g., according to Figures 1 or 2, are shown in exemplary manner in Figures 3 to 9. With the embodiments of Figures 3 to 9, the radiation source device 10 comprises a laser creating a pulsed laser beam, e.g., a femtosecond laser creating laser pulses with a duration of, e.g., 160 fs and a repetition period of, e.g., about 2 $\mu$s. The pulsed laser beam is focused as a sequence of emitter excitation pulses 2 with a focusing optic, like a lens 11, onto the photoemission electron source 21 of the electron source device 20.

The photoemission electron source 21 of Figures 3 to 7 and 9 comprises an emitter tip (see in particular Figure 9). In response to the focused pulse laser beam irradiation with the emitter excitation pulses 2, a correspondingly pulsed electron beam of source electron pulses 3 is created at the emitter tip. For directing the source electron pulses 3 along the optical axis z to the number state dispersion device 30, the electron source device 20 of each of the illustrated embodiments may optionally further include a suppressor anode 22, an extractor anode 23 (see also Figure 9), a beam-limiting aperture 20A and an accelerator and condenser optics 24 (see Figure 3). Preferably, the beam-limiting aperture 20A is arranged between the extractor anode 23 and the accelerator and condenser optics 24.

According to the embodiments of Figures 3 and 4, the number state dispersion device 30 is an energy-dispersive device comprising an energy-dispersive magnetic prism 31, which may be configured as described e.g., in [58,61,62]. Preferably, a single energy dispersive magnetic prism 31 may be provided. With the energy dispersive magnetic prism 31, different deflections relative to the optical axis z are applied to source electron pulses having different charges/energies in a deflection field of the energy dispersive magnetic prism 31. As an example shown, sub-pulses 4 with number state n = 2 are deflected with a larger output angle compared with the sub-pulses 4A with number state n = 1. Deflection with spatial separation of the sub-pulses is provided towards the number state selector device 40.

The number state selector device 40 comprises a mechanical beam block 41 acting as a spatial modulator of the electron beam intensity of the spatially separated sub-pulses. The mechanical beam block 41 of Figure 3 is configured for passing the selected sub-pulses 4 with number state n = 2 only to the sample and/or application site 50, while the sub-pulses 4A with number state n = 1 are blocked. To this end, the mechanical beam block 41 may comprise a beamblock material positioned in the path of the sub-pulses 4A to be blocked and transmitting the selected sub-pulses 4. Alternatively, the mechanical beam block 41 may be described as a slit, e.g. a circular slit passing the selected sub-pulses 4. As a further alternative, for selecting the sub-pulses 4A with number state n = 1 only and blocking the sub-pulses 4 with number state n > 1, in particular n = 2, the mechanical beam block 41 may comprise a circular beamblock material including a central hole, as shown in Figure 4.

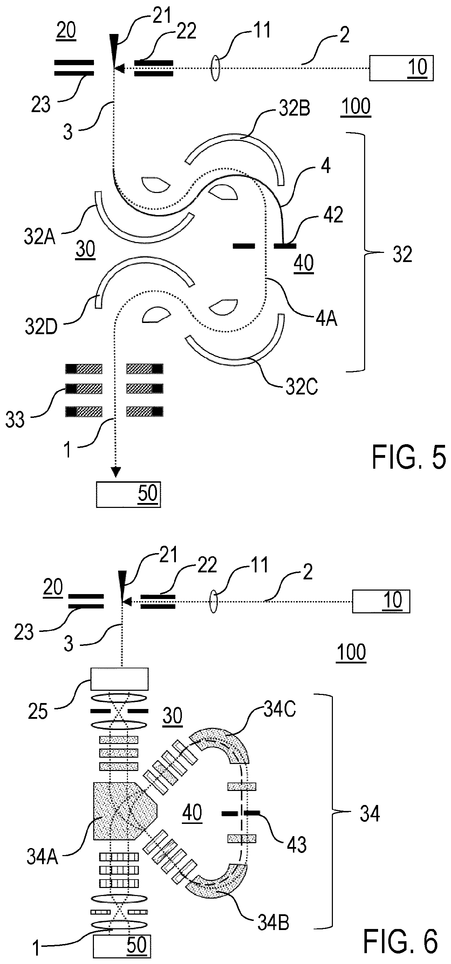

Figure 5 shows further details of an electron beam apparatus 100, e.g., according to Figures 1 or 2, wherein the number state dispersion device 30 comprises an in-column Omega Type monochromator filter 32 including the number state selector device 40 provided by a slit 42. The in-column Omega Type monochromator filter 32 may be configured as described e.g., in [58, 61]. The monochromator filter 32 comprises four magnetic prisms 32A to 32D deflecting the pulsed electron beam of source electron pulses 3 into the shape of a Greek letter Ω and acting as an energy filter.

By the effect of the deflection fields of the first pair of magnetic prisms 32A and 32B and depending on the number state of the received source electron pulses 3, the source electron pulses 3 are spread as sub-pulses 4, 4A onto different beam paths through the monochromator filter 32 towards the slit 42. The slit 42 can either block outer n > 1, e.g., n = 2, state sub-pulses 4 and pass central n = 1 state sub-pulses 4A. Alternatively, the slit 42 may be replaced by a beam-stop (not shown) at the slit position that transmits only the outer n > 1 state sub-pulses and blocks the central n = 1 state sub-pulses.

By the effect of the deflection fields of the second pair of magnetic prisms 32C and 32D, the selected sub-pulses passed by the slit 42 (or the beam-stop) are re-deflected onto the initial direction of the source electron pulses 3 and directed as the electron pulses 1 to be obtained towards the sample and/or application site 50. For adjusting the electron kinetic energy to the requirements if the application/sample 50, an accelerator 33 is placed behind the monochromator 32, but can optionally also be placed before 32.

According to the embodiment of Figure 6, an electron beam apparatus 100, e.g., according to Figures 1 or 2, includes the number state dispersion device 30 having an in-column Alpha-Type monochromator 34 including a slit 43. The slit 43 provides a mechanical beam block of the number state selector device 40. The pulsed electron beam of source electron pulses 3 created at the emitter tip 21 is directed via condenser optics and an accelerator 25 to the Alpha-Type monochromator 34.

The Alpha-Type monochromator 34 may be configured as described e.g., in [58, 61, 64]. The monochromator 34 includes imaging optics and three magnetic prisms 34A to 34C deflecting the pulsed electron beam of source electron pulses 3 into the shape of a Greek letter α and acting as an energy filter. Like with the monochromator filter 32 of Figure 5, the source electron pulses 3 are spread as sub-pulses 4, 4A onto different beam paths through the monochromator 34 towards the energy-selecting slit 43. The slit 43 can block outer n > 1, e.g. n = 2, state sub-pulses 4 and pass central n = 1 state sub-pulses 4A. Alternatively, a central beam-stop (not shown) at the slit position may be employed for transmitting only the outer n > 1 state sub-pulses and blocking the central n = 1 state sub-pulses. The selected sub-pulses transmitted by the slit 43 (or around the central beam-stop) is imaged towards the sample and/or application site 50.

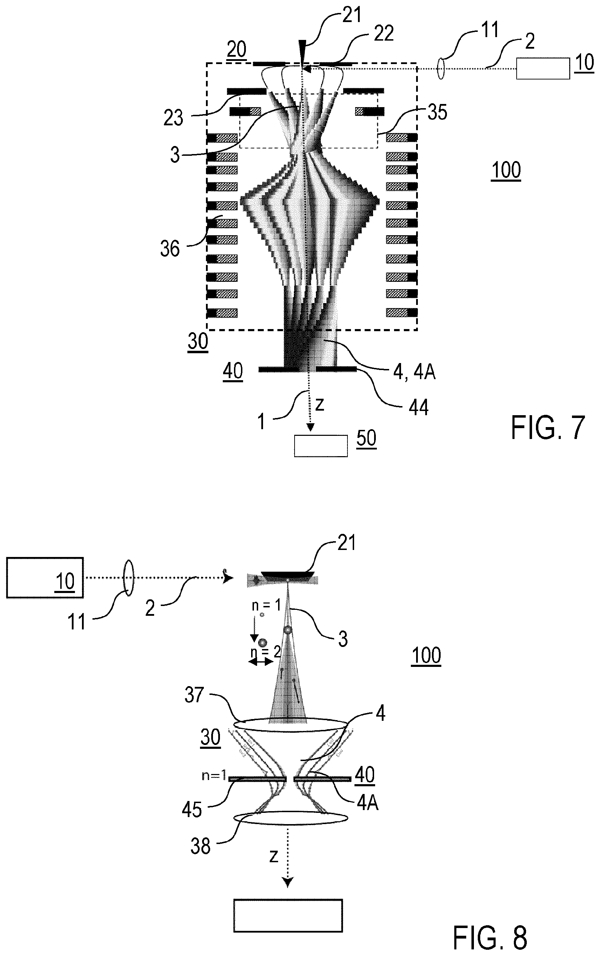

As a further alternative embodiment, the electron beam apparatus 100 of Figure 7 includes a Wien-type monochromator 35 as the number state dispersion device 30. The Wien-type monochromator 35, which may be configured as described e.g., in [61, 64], is arranged in combination with an accelerator 36 directly downstream of the extractor anode 23. As an alternative to the Wien-type monochromator 35 as shown, a Double-Wien-type monochromator may be employed. The Wien-type monochromator 35 acts as an energy-selective imaging system directing pulses with different electron number states on beam paths with different angles relative to the optical axis z of the electron source device 20. Accordingly, sub-pulses 4, 4A are spatially separated, allowing a selection of the sub-pulses depending on the number state thereof. The schematic color scale illustration in Figure 7 is encoding the kinetic electron energy, as dispersed by the Wien filter.

The number state selector device 40 comprises a slit 44 arranged with a distance downstream from the Wien-type monochromator 35. The slit 44 acts as a spatial modulator of the electron beam intensity of the spatially separated sub-pulses. Depending on the position of the slit 44 relative to the optical axis z, the slit 43 can either block n > 1 states or transmit only n = 2 states.

Figure 8 illustrates the formation of a virtual source size and position at the apex of the tip-shaped photoemission electron source 21 of the electron beam apparatus 100. In response to the focused pulse laser beam irradiation from the radiation source device 10 via lens 11, the emitter excitation pulses 2 create a pulsed electron beam of source electron pulses 3 with a virtual source size on the emitter tip and virtual source shift depending on the number state of the pulses. In particular, the virtual source size additionally increases (see double-arrow) with increasing number state of the electron pulses excited, and the virtual source additionally shifts along the optical axis z (see arrow) with increasing number state of the electron pulses excited.

The number state dispersion device 30 of the embodiment of Figure 8 comprises a pair of electron lenses 37, 38 being arranged with a common optical axis z perpendicular to the surface of the emitter tip shaped photoemission electron source 21. The electron lenses 37, 38 are arranged with a mutual axial distance including the number state selector device 40. The number state selector device 40 comprises a circular aperture 45 made of a beam blocking material with a hole centered with the optical axis z. Alternatively, number state selector device 40 comprises a circular beam blocker (not shown) centered with the optical axis z.

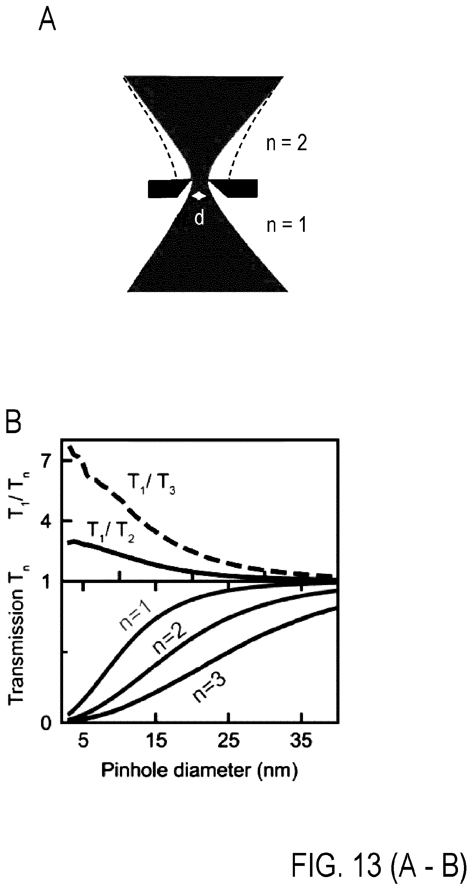

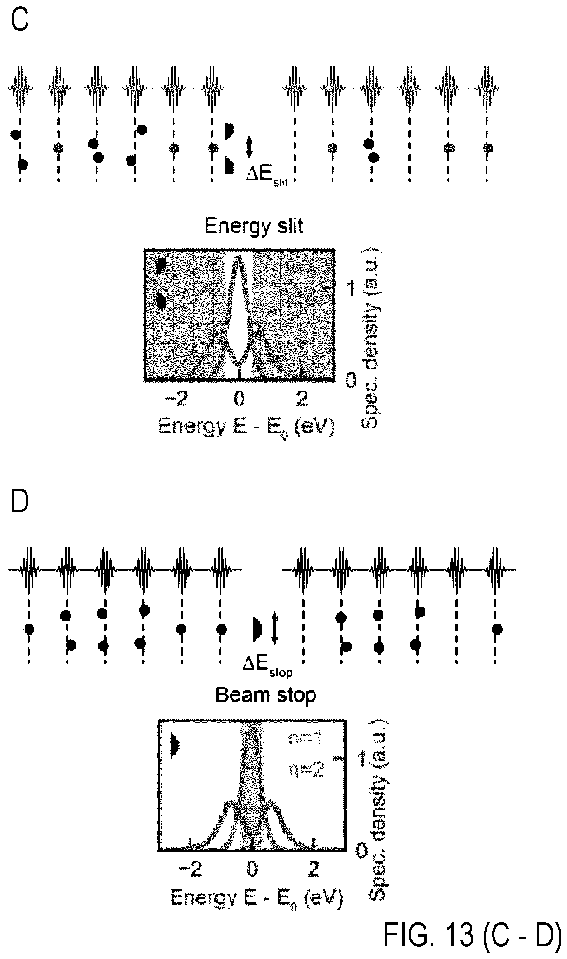

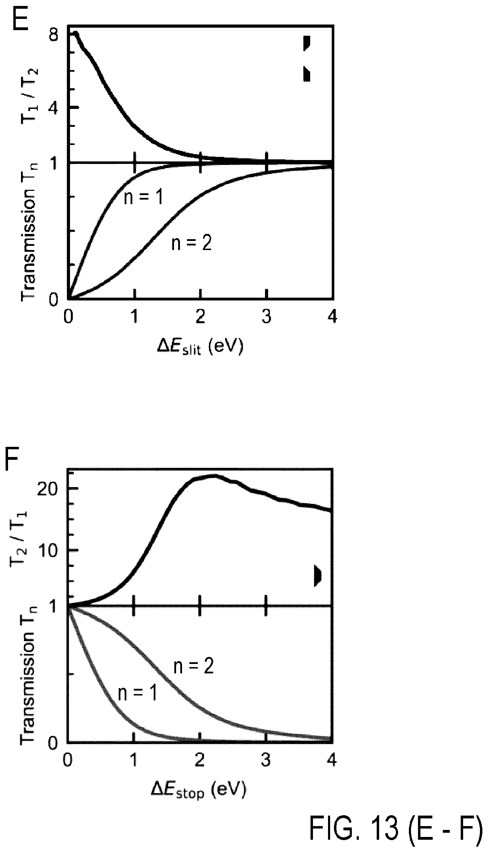

The emitter tip of the photoemission electron source 21 provides a virtual source size depending on the number state of source electron pulses 3 excited. This characteristic creates an angular/spatial dispersion of the source electron pulses 3 which is visible in a beam caustic after the first electron lens 37, as schematically illustrated in Figure 8 (see also Figure 13). With increasing virtual source size, i.e., with increasing number of the number state, a diameter of the beam caustic after the first electron lens 37 increases as well. Accordingly, depending on the aperture or blocker type and depending on the position of the number state selector device 40, sub-pulses 4 with a specific number state, e.g., n = 1, can pass the number state selector device 40, while sub-pulses 4A with other number states, e.g., n = 2 and n = 3, are blocked by the number state selector device 40. With the second electron lens 38, the sub-pulses 4 (pulsed electron beam to be generated) transmitted by the number state selector device 40 are imaged onto the sample and/or application site 50.

With regard to each of the Figures 5 to 8, it is noted that the mean kinetic energy of the electron pulses may be adjusted with an electrostatic electron accelerator (see e.g., 33 in Figure 5, or 36 in Figure 7), which may be placed at any position of the beam path between the emitter unit and the application/sample, but preferably before the number state dispersion, or after the number state selective device.

In the following, further practical embodiments and experimental tests of the invention are described with reference to Figures 9 to 13.

With the practical tests by the inventors, strong Coulomb correlations in two-electron and three-electron states generated at a laser-driven Schottky field emitter are demonstrated as shown below. Using event-based electron spectroscopy and imaging, kinetic energy distributions of electron ensembles emitted by single laser pulses are recorded, sorting events by the number of free electrons. Characteristic double and triple-lobe spectra for events containing for instance two and three electrons, respectively, are found. The invention allows quantitatively characterizing interparticle correlations in both energy and transverse momentum, and observes that stochastic fewbody interactions dominate over mean-field (space charge) effects. Two-particle energy correlation functions reveal a pronounced peak at around 1.7 eV energy difference, illustrating an effective joint emission area for electron pair-states far smaller than the physical and virtual source sizes. The findings shed light on fundamental correlations in multielectron emission, and enable statistical control of electron beams for on-demand correlated few-particle imaging and spectroscopy.

Figure 9 illustrates creating Coulomb-correlated few-electron states in an electron beam apparatus 100 according to embodiments of the invention. The electron beam apparatus 100 is based on a transmission electron microscope with a microscope column 101 having an optical axis z, e.g., the Ultrafast Transmission Electron Microscope (UTEM) as described in [48].

The microscope electron source at an upper end of the microscope column 101 provides the electron source device 20 with the tip shaped photoemission electron source 21, which is shown with an enlarged scheme in the upper right section of Figure 9. The tip shaped photoemission electron source 21 comprises a Schottky field emitter, e.g., a tungsten (W)/ZrOx nanotip with an W(100) facet 21A covered with a ZrOx layer. The photoemission electron source 21 has radius-of-curvature of e.g., r = 490 nm, and it is operated at an extraction voltage of e.g. $U_{ext}$ = 2 kV and a bias voltage of $U_{bias}$ = -0.3 kV. The photoemission electron source 21 may be cooled during operation. Cooling may be provided just below the continuous Schottky-emission threshold.

The photoemission electron source 21 is arranged for the focused irradiation with the emitter excitation pulses 2 and for creating pulsed photoemission, in particular linear photoemission. The emitter excitation pulses 2 (e.g., 160 fs pulse duration, 515 nm central wavelength) are created with a repetition rate of e.g., 600 kHz using a femtosecond laser source 10 and focused onto the tip-shaped photoemission electron source 21 with the lens 11.

Furthermore, the electron source device 20 is provided with a suppressor anode 22 and an extractor anode 23 for directing and accelerating ultrashort source electron pulses 3 emitted with the repetition period $T_{rep}$ from the laser-assisted Schottky field emitter (nanotip) onto the optical axis z. Few electron-states are prepared by the pulsed photoemission, i.e., the source electron pulses 3 are created with a pulse charge of few electrons after passing the extractor anode 23 and optionally another beam limiting apertures 23A.

Each source electron pulse 3 represents an n-electron event, as illustrated in the upper right section of Figure 9. Each of the emitter excitation pulses 2 results in the creation of e.g., n = 0 (no electron pulse), n = 1 (one electron per pulse), n = 2 (two electrons per pulse), n = 3 (three electrons per pulse) or even n above 3. However, according to experimental tests by the inventors, pulses with n > 4 have a lower probability. The source electron pulses 3 may have a low pulse charge, i.e., the source electron pulses 3 include on average less than one electron per pulse in the sample plane.

At the lower end of the microscope column 101, the number state dispersion device 30 is arranged. The number state dispersion device 30 comprises an imaging energy filter (as shown in Figures 3/4) deflecting the source electron pulses 3 with a deflection angle relative to the optical axis z. The deflection angle depends on the state number of the source electron pulses 3, so that the source electron pulses 3 with different state numbers are spatially separated as sub-pulses 4 of the sequence of electron pulses. This spatial separation is schematically shown with the illustration of a sum source electron pulse 3 including any number states and further separated sub-pulses 4, e.g., with number states n = 1, n =2 and n = 3.

Subsequently, post-selection of sub-pulses 4 with one of the number states is provided using the number state selector device 40, which transmits the selected sub-pulses as the pulsed electron beam 1 to be obtained. The number state selector device 40 may be provided e.g., as described in one of the above Figures 1 to 8.

Downstream of the number state selector device 40, a time resolved event-based electron detector camera 105, like a Timepix3 ASIC (EM CheeTah T3, Amsterdam Scientific Instruments B.V.), may be arranged for an event-based electron spectroscopy enabling number state selective beam analysis in particular for the tests described here. The temporal resolution of the electron detector camera 105 allows to discriminate between consecutive incident electron pulses, providing an unambiguous measure of the number n of transmitted electrons per laser pulse. With practical applications of the invention, the detector camera 105 preferably is replaced by the sample and/or application site 50, like a sample stage, or, alternatively, the detector camera 105 may be combined with the sample and/or application site 50.

The microscope is shown in Figure 9 with a typical configuration including objective lenses 102, 103 and a sample stage 104 in a sample plane for illustrative purposes only. The electrons pass the sample plane of the microscope. With plural embodiments, the objective lenses 102, 103 and the sample stage 104 are not used for implementing the inventive technique and can be omitted. However, with the embodiment of Figure 8, the objective lenses 102, and 103 may provide the pair of electron lenses 37, and 38, the sample stage 104 may be used for providing the number state selector device 40, and units 30 and 40 at the downstream end of column 101 can be omitted.

Figure 10A illustrates the number of n-electron states per pulse detected with the electron detector camera 105 of Figure 9 in dependency on laser power of the emitter excitation pulses 2. For the measurements, the detector camera 105 may be operated as follows. The detector camera 105 may generate a stream of data packages containing the position of electron-activated detector pixels, their time-of-arrival (ToA), which are digitized with 1.56 ns time bins, and the energy (time-over-threshold, ToT) associated with the incident electron events. At a beam voltage of e.g., 200 kV every individual electron activates a cluster of pixels with variable size ($N_{pixels,avg} \approx 8$ pixels), shape and energy ($ToT_{avg} \approx 280$ a.u.). Single-electron event localisation of the ToT-corrected raw data stream is achieved, e.g., using the Division of Nanoscopy, M4I, Maastricht University event clustering code [59], which is based on a Hierarchical Density-Based Spatial Clustering (HDBSCAN) in Python3. The algorithm reconstructs the timing and position of individual electrons incident on the detector from the activated pixel clusters (hits). Thereby, individual electrons are distinguished in terms of their ToA, attributing between three and nine neighbouring pixels activated within a time window of 100 ns and a summed pixel energy ToT ranging from from 200 a.u. to 400 a.u. to the same cluster (see [60]). The photoelectrons are clustered according to the femtosecond laser pulse that generated them. The temporal resolution of the detector (e.g., 1.56 ns) is much faster than the temporal pulse separation given by the laser repetition rate ($\approx 1\mu s$), but much slower than the temporal splitting of the correlated electrons at the detector ($\approx 1ps$). Hereby, the electrons arriving at the detector within $\Delta t_n = 50$ ns are assigned to a number-class electron state n = 1,2,3,... determined by the number of electrons in one laser pulse.

As shown with the power-scaling of one-, two and three-electron states in Figure 10A, the ratio of single-electron pulses compared to the total number of emission events scales linearly with the photoexcitation laser power, in agreement with the employed process of near-threshold laser-assisted Schottky photoemission [48, 49]. Figure 10B shows in an exemplary manner, how one-photon laser-assisted near-threshold Schottky emission generates the one-electron states.

Similarly, the two and three-electron rates increase with the power of n. Considering the relative distribution of n-electron events at a given laser power, weakly sub-Poissonian statistics are identified. Specifically, defining $P_n$ as the probability to detect n electrons in a pulse, a Poisson process predicts a probability distribution of $P_n = r_n P_1^n / n!$ with $r_n$ = 1. The actual rates measured for $n \geq 2$ are somewhat lower, corresponding to bunching ratios of $r_2 = 0:85$ and $r_3 = 0:57$, respectively. This confirms moderate antibunching of few-electron states, as recently observed from different field emitters for the case of n=2 [19, 24, 25].

Investigating the kinetic energies of the number sorted electron states is illustrated in Figures 10C to 10 F, which show how the event-averaged spectrum (Figure 10C) may be separated into number-state resolved contributions (n = 1, 2, 3, Figures 10D to 10F). The two- and three-electron spectra show a distinct shape with n peaks, indicating a discrete energetic separation of the contained electrons.

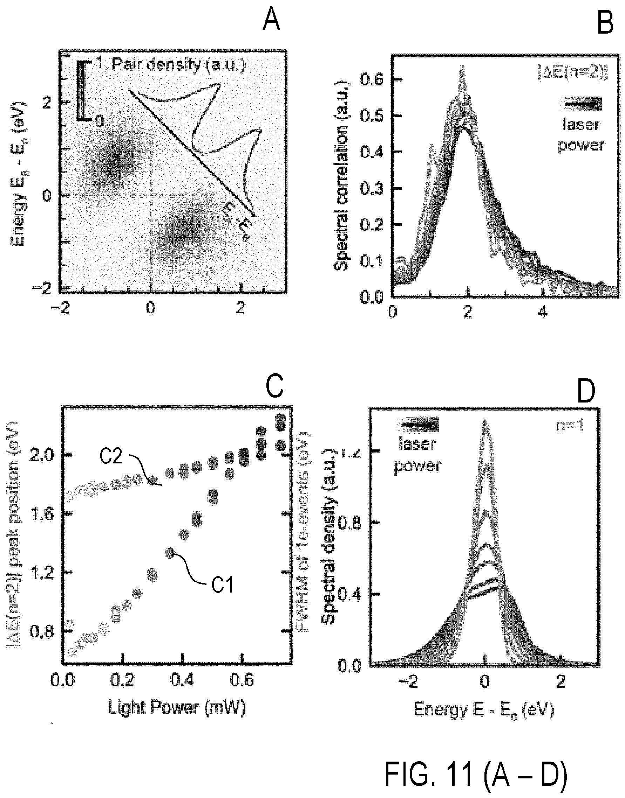

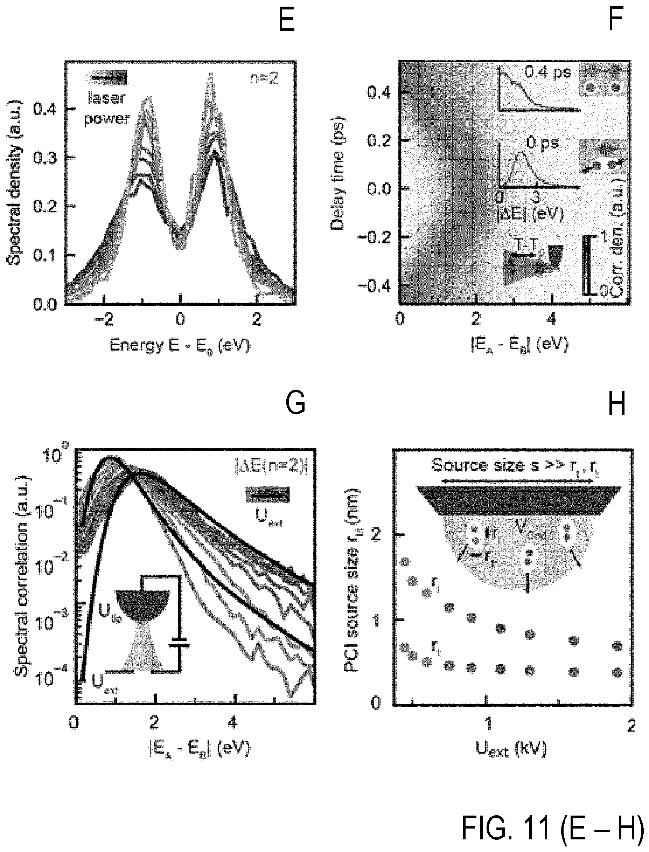

The spectral distribution of the one-electron events (Figure 10D), which also dominates the total spectrum (averaged over all events), consists of a single peak centered around the acceleration voltage of $E_0 = 200$ keV. In stark contrast, the spectra of the two- and three-electron events exhibit a pronounced double- and triple-lobe structure, respectively, with a mean energy at $E_0$. Beyond the average over similar events, as shown in Figures 10 C to 10F, measurement schemes of the inventors further allow linking the spectral characteristics to two- and three-particle correlations within individual electron pulses, as shown in Figure 11. Figure 11 illustrates electron pair state generation at the tip shaped photoemission electron source 21 (see Figure 9), wherein Fig-ure 11A shows an energy histogram of coincident electron pairs revealing a strong correlation in relative kinetic energy, visible in the spectral correlation function (inset, integrated along the diagonal), and Figure 11B shows normalized one-sided pair correlation functions (n = 2) for varying laser power. Figure 11C shows power scaling of the peak position of the n = 2-correlation function compared to the spectral width (FWHM) of the n = 1-state (spectra with varying laser power shown in Figure 11D). Figure 11E shows normalized n=2-spectra for varying laser power, and Fig-ure 11F shows a pair correlation function for photoemission with two delayed laser pulses. In temporal overlap, a strong correlation gap is observed, disappearing for about 200 fs pulse delay (see cross sections as inset). Figure 11G shows extraction voltage $U_{ext}$ dependent spectral correlation function (solid lines: fitted spectral distribution), and Fig-ure 11H shows transverse ($r_{tra}$) and longitudinal ($r_{lon}$) dimensions of the extracted correlation volume from Figure 11G (inset: illustration comparing correlation volume with virtual source size).

For the two-laser-pulse generation described with reference to Figures 11F and 11H, a Michelson interferometer may be used which splits an incoming laser pulse into two separate pulses. One of the interference arms has a variable optical path length, implemented by a retro reflector mounted on delay stage with a bidirectional repeatability of (value). The optical path difference can be tuned to a delay time difference between the two pulses of up to e.g., 10 ps.

With more details, Figure 11A shows the pair-density distribution of the electron energies $E_A$ and $E_B$ associated with two electrons A and B assigned to the same electron pulse. Coulomb repulsion results in a pronounced gap in the energy difference $E_A - E_B$, and a broadening of the sum energy $E_A + E_B$ which partially reduces the observed gap in the total spectral density. This strong correlation proves that the observed splitting of the n = 2 spectrum into a double-lobed structure is the result of a two-electron interaction arising from Coulomb repulsion.

Similar to a conventional (not laser-triggered) Schottky source, only a fraction of electrons generated at the emitter surface is transmitted into the microscope column 101 (see Figure 9). Consequently, mean-field (space charge) as well as stochastic interactions with random nearby electrons not entering the beam may be considered and distinguished from the correlation observed in the electron pair state. Laser-power-dependent measurements allow for an assessment of these different contributions. The corresponding n = 1 and n = 2 (Figures 11D, 11E) spectral distributions exhibit a broadening with increasing laser power (cf. Figure 11C, circles C1), i.e., with average photocurrent. This is in close correspondence to previous non-event-selective measurements [28, 31, 50] and is typically ascribed to stochastic Coulomb interactions and mean-field effects.

In contrast, the set of two-electron correlation functions displayed in Figure 11B is remarkably independent of laser power, showing a pronounced gap that is about 1 eV wide, a peak at around 1.8 eV, and an extended tail towards high energy separations exceeding 4 eV. Increasing the photocurrent only imposes moderate variations in the depth of the gap and the shape of the high-energy tail. In particular, the position of the main correlation peak (Figure 11C, circles C2) approaches a fixed value of 1.7 eV towards vanishing laser power and thus average current. This demonstrates that the observed correlation is only weakly altered by multiple Coulomb interactions with aperture-blocked electrons, and that it is dominated by the two-electron correlation alone.

In order to investigate the temporal extent over which such strong Coulomb correlations prevent the observations of independent single electrons, measurements are conducted using a pair of laser pulses of variable delay (see Figure 11F) and at constant integrated laser power. Two different ranges are identified: Temporally overlapping laser pulses reproduce the described n = 2 correlation function. In contrast, a temporal separation of more than 200 fs coincides with a significantly reduced energy difference, indicative of two individual, uncorrelated electron emission events.

Whereas there is only weak dependence of the correlation on emission current, the inventors found that the extraction field applied to the tip has a more prominent influence. A decrease in extraction voltage substantially changes the observed gap and the slope of the high-energy tail (see semilogarithmic plot in Figure 11G). Physically, a change in extraction voltage affects the height of the Schottky barrier and the acceptance angle of the beam. The spectral shapes of these correlation functions can be modeled in a straightforward manner by an ensemble of electron doublets prepared with a Gaussian-distributed interparticle distance, and assuming that the initial interparticle Coulomb energy is magnified by acceleration in a static electric field, resulting in a larger kinetic energy difference. Using separate standard de-viations $r_{lon}$ and $r_{tra}$ for the longitudinal (perpendicular to the surface) and transverse (parallel to the surface) distributions, respectively, this simple model successfully describes the main features of the measured correlation functions (cf. solid lines in Figure 11G).

The physical source size of the Schottky field emitter, as well as the back-projected virtual source size, should be in the range of more than 20 nm [51]. However, as the correlation function nearly vanishes at zero energy difference, there are hardly any additional events containing two uncorrelated (or weaker-correlated) electrons. This is noteworthy, as the rate of Coulomb-correlated electron doublets amounts to 85 % of what is expected from a Poisson number distribution and the one-electron rate. The lack of 15 % of two-electron events (antibunching) could be attributed to local Coulomb blockade [52, 53], Pauli blocking [24], or transverse interparticle deflection and spatial filtering.

In other words, the statistical occurrence frequency of two-electron events is rather close to what would be expected from uncorrelated emission events from the extended nanoscale source.

In order to explain the concurrent enhancement of electron pair emission, the inventors note some mechanisms which were previously invoked in atomic and molecular contexts as well as two-electron photoemission. In atoms exposed to strong laser fields, enhanced "non-sequential" double ionization has been observed, initially in Helium [54] and subsequently in many other elements. Various mechanisms including co-tunneling, shake-up processes, and rescattering of a field-driven electron have been used to describe the observations, while the latter mechanism appears to be responsible in most cases [33, 34]. At the rather moderate local intensities in experiments of the inventors, the ponderomotive potential is significantly below 1 meV, such that recollision can be ruled out as a dominant factor. In the linear regime, one-photon two-electron emission is common in the Auger effect, where a core-hole resulting from photoemission is filled during the concurrent emission of a second electron. Coulomb interaction is a dominant factor in this process [55].

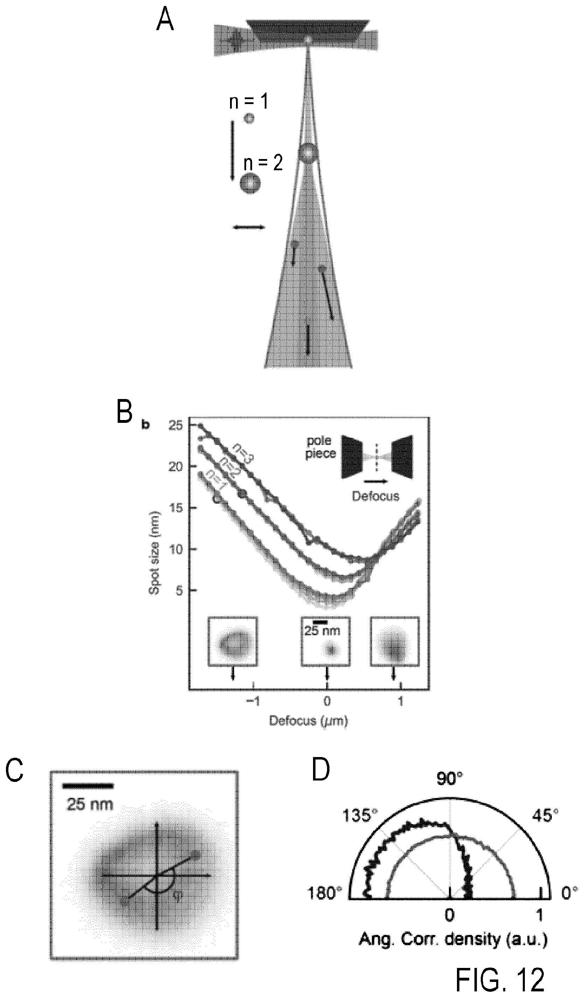

Figure 12 shows a characterization of the spatial beam properties of few-electron states. Figure 12A is a schematic of spatial filtering by the effect of Coulomb interaction. For an integer rising pulse charge, the virtual source increases in size (see double arrow) and is shifted along the electron beam axis z (see vertical arrow). Figure 12B shows caustics of the electron beam sorted by n, recorded by varying the last condenser lens 38 of the electron beam apparatus 100. The insets of Figure 12B show images of the beam profile for n = 2 in underfocus (left), focus (middle) and over-focus (right). Figure 12C is an image of the beam profile in underfocus, with correlation angle φ between electron pairs with respect to the beam center. Long angle legs in the underfocus condition allow a precise measurement of the angular correlation, and Figure 12D shows a strong anisotropic angular correlation is observed for n = 2, compared to an isotropic distribution for drawing random events (employed datasets indicated in Figure 12B by black circles around the data points).

With further details, Figure 12 shows that, alongside their spectral distributions and correlations, the few-electron states observed here exhibit characteristic spatial properties, as discussed in the following. Specifically, Figure 12B illustrates n-dependent beam caustics, which exhibit discrete differences in both minimum spot size and focal position, resulting in separated sub-pulses. Variations with laser power yield changes to the caustics (higher power leads to some increase in spot size), but are far less pronounced than the differences between the event classes. Under the given conditions, the focusability may be limited by spherical aberration of the objective lens and the virtual source size, which result in typical spot profiles for positive and negative defocus (inset in Figure 12B). Evidently, the $n \geq 1$ caustics are the result of a larger effective source, and the beam waist is shifted towards positive defocus.

Both observations can be understood from mutual transverse deflection sketched in Figure 12A. Specifically, transverse deflection is expected to laterally spread the few-electron trajectories [31], such that the virtual source increases in size and moves forward, as previously predicted in simulations [52, 57].

A more detailed analysis of the spatial properties of few-electron states is obtained by analyzing correlations in transverse momentum. To this end, the inventors measured position correlations for a sufficiently large negative defocus (Figure 12C). The spatial correlation is quantified via the angle φ between the two electrons and the beam center. Figure 12D shows the angular correlation density of the two-electron state compared with random correlations drawn from a corresponding single-electron state at the same spot size (15 nm). In the electron pair state, we obtain a strong anisotropic correlation peaked around an angle of 180deg, corresponding to electron events localized on opposite sides of the defocused beam, and thus having nearly opposite transverse momenta.

These observations show that averaging over number states has a severe impact on the beam properties, including non-correctable stochastic aberrations. A control of the number statistics in the photoemitted beam may thus directly benefit microscopy applications with such sources. More generally, stochastic Coulomb interactions are a fundamental issue in electron microscopy, limiting electron source brightness via altering a beam's transverse (Loeffler) and longitudinal (Boersch) momentum distributions. The moderate antibunching observed here and in previous work [25] implies that the total photocurrent exhibits weakly sub-Poissonian noise characteristics, a property highly sought after in condensed matter scenarios (e.g., achieved by Coulomb blockade). In the context of electron microscopy, this feature could be directly applied for shot-noise reduction in imaging, spectroscopy and lithography. However, perhaps even greater potential arises from the strong Coulomb-correlations identified for the electron doublet (n = 2) state. The fact that both electrons in this state are energetically well-separated from each other and from the central energy allows for an energetic selection of the respective number state. This facilitates a powerful approach to control the statistics of single- and double electron events by energetic selection.

Figure 13 illustrates a statistical control of single- and double-electron states using spatial and spectral filtering, wherein Figure 13A shows a scheme of spatial filtering with a circular aperture and Figure 13B shows transmission rates for spatial filtering. Figure 13C (double electron state suppression) demonstrates that an energy slit significantly reduces the transmission of laser-pulse generated n=2- electron states with respect to n=1-electron states, wherein spectra of n = 1 and n = 2 electron states are shown. Electron energies in the dark-shaded region are truncated by the energy slit. On the other hand, Figure 13D (double electron state enhancement) demonstrates that an energy beam stop significantly reduces the transmission of n = 1-electron states with respect to n = 2-electron states, wherein spectra of n = 1 and n = 2 electron states are shown. Electron energies in the dark-shaded region are truncated by the energy beam stop.

Figure 13E shows a plot of the transmission $T_n$ and transmission rate $T_1 / T_2$ for varying energy slit widths with an up to 8-fold enhancement of n = 1-electron states (for the setup shown in Fig. 13C) and Figure 13F shows a plot of the transmission $T_n$ and transmission rate $T_2 / T_1$ for varying energy stop widths with a more than 20-fold enhancement of n = 2-electron states (for the setup shown in Fig. 13D).

With more details, a pre-specimen energy filter commonly used in state-of-the-art electron microscopes [58] could be used to selectively favor particular number states. Specifically, such an energy slit with a pinhole diameter d truncates the transmitted energy spectrum and can therefore be adjusted in width to strongly favor the transmission probability for n=1 over n=2 states (see Figure 13C). Specifically, for experimentally measured single electron and double-electron spectra (Figure 13E), the n=1 transmission probability exceeds the n = 2 transmission probability by a factor of 8 at small slit widths, greatly enhancing the sub-Poissonian nature of the electron number distribution and facilitating a shot-noise-reduced electron current. Conversely, a central beam stop in energy can suppress a substantial fraction of single-electron states, leading to an up to 20-fold enhancement of pair-state over n = 1 state transmissions (see Figures 13D, 13F). This approach will enable new forms of microscopy and spectroscopy with correlated electrons for a variety of novel two-point or two-time measurement schemes in correlated materials and free-electron quantum optics.

In summary, the invention demonstrates a novel approach to exert unprecedented control over the statistics in a pulsed charged particle beam, generating femtosecond pulses containing well-defined integer electron charges Q = ne. The number of electrons n in each state can be traced not only directly by event-based detection, but is also strikingly imprinted onto the spectral and angular distribution of the beam. This will enable altering the particle statistics of an electron beam, simply by blocking part of the time-averaged intensity in an energy-dispersive plane, in transverse momentum, or at a focused beam position, thus filtering specific number states efficiently. Rejecting beam states n > 1 can efficiently generate sub-Poissonian beams with direct implications for shot-noise-reduced electron imaging and lithography. Furthermore, selecting specific number states allows for borrowing concepts from quantum optics. For example, n = 2 constitutes a highly on-classical state, that can be employed to implement a high-fidelity electron-heralded single-electron, that would enable shot-noise free (or reduced) electron imaging and lithography with precisely countable number of electrons, lifting a previously considered fundamental limit. Furthermore, the fundamental scattering processes involved in creating multi-electron states can be generally assumed to induce entanglement between multiple electrons, in absence of additional entanglement-breaking reporting channels, like potentially residual electron holes in the photoemitter, or coupling to an external thermal bath. Future studies will have to address the quantum coherence of such multi-electron states, promising novel quantum technology using free-electrons, potentially enabling interaction-free measurements and ghost imaging, quantum teleportation and information processing, and finally entangled free-electron qubits for fermionic quantum computation.

The features of the invention disclosed in the above description, the drawings and the claims can be of significance both individually as well as in combination or sub-combination for the realization of the invention in its various embodiments. The invention is not restricted to the preferred embodiments described above. Rather a plurality of variants and derivatives is possible which also use the inventive concept and therefore fall within the scope of protection as defined by the appended claims.

## Claims

1. Electron beam apparatus (100), configured for generating a pulsed electron beam (1), comprising a sequence of electron pulses, comprising

    - a radiation source device (10) being arranged for creating a sequence of emitter excitation pulses (2), in particular laser pulses,
    - an electron source device (20) having a photoemission electron source (21), which is arranged for radiation-induced emission of source electron pulses (3) in response to an irradiation with the emitter excitation pulses (2),
    - a number state dispersion device (30) being arranged for spatially separating the source electron pulses (3) into sub-pulses (4, 4A), wherein each sub-pulse (4, 4A) includes an integer electron number (n), with n = 1, 2, 3, ..., and
    - a number state selector device (40) being arranged for selecting sub-pulses (4, 4A) comprising at least one set of predetermined electron number states as the pulsed electron beam (1) to be generated.

2. Electron beam apparatus according to claim 1, wherein

    - the photoemission electron source (21) is configured for generating countable low-charge electron pulses, preferably including 1, 2, 3 or 4 electrons per pulse.

**3.** Electron beam apparatus according to one of the foregoing claims, wherein

- the photoemission electron source (21) comprises a beam-limiting aperture (20A) configured for reducing high-charge electron pulses to countable low-charge electron pulses.

**4.** Electron beam apparatus according to one of the foregoing claims,

- the photoemission electron source (21) is configured for generating multi-electron states with distinguishable properties in addition to the pulse charge.

**5.** Electron beam apparatus according to one of the foregoing claims, wherein the number state dispersion device (30) comprises an energy-dispersive device.

**6.** Electron microscopy apparatus according to claim 5, wherein the energy-dispersive device comprises

- a beam monochromator, in particular a beam monochromator of the omega-type, alpha-type, Wien-Filter-type, Double-Wien-type, or electron-mirror type.

**7.** Electron microscopy apparatus according to claim 5, wherein the energy-dispersive device comprises

- a spectrometer device, in particular a spectrometer device comprising a magnetic prism or an electrostatic multipole electron optics.

**8.** Electron beam apparatus according to one of the foregoing claims, wherein the number state dispersion device (30) comprises a momentum dispersion device or a position dispersion device or an electron orbital momentum dispersion device, in particular at least one of a rotation-symmetric electron lens and a cylindrical electron lens.

**9.** Electron beam apparatus according to one of the foregoing claims, wherein the number state dispersion device (30) comprises an electron spin dispersion device.

**10.** Electron beam apparatus according to one of the foregoing claims, wherein

- the number state selector device (40) comprises a spatial modulator of the electron beam intensity, in particular being configured for passing the selected sub-pulses (4, 4A) with the predetermined electron number state and blocking the remaining sub-pulses (4, 4A).

**11.** Electron beam apparatus according to one of the foregoing claims, wherein

- the number state selector device (40) comprises at least one of a mechanical slit, grating, linear beam block, hole, ring or disk.

**12.** Electron beam apparatus according to one of the foregoing claims, further comprising

- a detector device being configured for determining a number of electrons within at least one of the electron number states of the pulsed electron beam (1), and

**13.** Electron beam apparatus according to one of the foregoing claims, further comprising

- a beam-forming electron optics being configured for illuminating a sample, like a sample to be investigated and/or a workpiece, like a semiconductor workpiece.

**14.** Electron beam apparatus according to one of the foregoing claims, wherein

- the photoemission electron source (21) comprises a tip-shaped photoemission electron source.

**15.** Electron microscopy apparatus, provided with the electron beam apparatus according to one of the foregoing claims.

**16.** Method of generating a pulsed electron beam (1), comprising a sequence of electron pulses, comprising the steps of

- creating a sequence of emitter excitation pulses (2), in particular laser pulses, with a radiation source device (10),
- irradiating a photoemission electron source (21) of an electron source device (20) with the emitter excitation pulses (2), so that source electron pulses (3) are created by radiation-induced emission,
- spatially separating the source electron pulses (3) into sub-pulses (4, 4A), wherein each sub-pulse (4, 4A) includes an integer electron number (n), with n = 1, 2, 3, ..., with a number state dispersion device (30), and
- selecting sub-pulses (4, 4A) comprising at least one set of predetermined electron number states as the pulsed electron beam (1) to be generated, with a number state selector device (40).

**17.** Method according to claim 16, including the step of

- adjusting the radiation source device (10) and/or the photoemission electron source (21) for generating multi-electron states, that are distinguishable by a property besides the pulse charge.

18. Method according to one of the claims 16 to 17, including the step of

- adjusting the number state dispersion device (30) according to a distinguishable property of the source electron pulses (3), in particular an energy, angle/momentum, spatial focus.

19. Method according to one of the claims 16 to 18, including the step of

- adjusting the number state-selector device for rejecting or blocking specific number states from the beam, in particular interesting for rejecting or blocking all n>2 or for rejecting or blocking all sub-pulses (4, 4A) with n ≠ 2.

20. Method according to one of the claims 16 to 19, including the step of

- adjusting the radiation source device (10), the photoemission electron source (21), the number state dispersion device (30) and/or the number state selector device (40) based on an output of an additional number-state sensitive detector.

21. Method of using the electron beam apparatus according to one of the claims 1 to 15 as a beam source in at least one of an electron microscopy apparatus, an electron lithography apparatus, an electron pairs (source) apparatus, an electron heralding apparatus, an electron counting apparatus, an information processing apparatus, a communication apparatus, and a quantum computing apparatus.

**Patentansprüche**

1. Elektronenstrahlvorrichtung (100), die zum Erzeugen eines gepulsten Elektronenstrahls (1), der eine Folge von Elektronenpulsen aufweist, ausgebildet ist, umfassend

- eine Strahlungsquelleneinrichtung (10), die zum Erzeugen einer Folge von Emitteranregungspulsen (2), insbesondere von Laserpulsen, angeordnet ist,
- eine Elektronenquelleneinrichtung (20), aufweisend eine Photoemissionselektronenquelle (21), die zur strahlungsinduzierten Emission von Quellenelektronenpulsen (3) als Reaktion auf eine Bestrahlung mit den Emitteranregungspulsen (2) angeordnet ist,
- eine Zahlenzustandsdispersionseinrichtung (30), die zum räumlichen Trennen der Quellelektronenpulse (3) in Teilpulse (4, 4A) angeordnet ist, wobei jeder Teilpuls (4, 4A) eine ganzzahlige Elektronenzahl (n) umfasst, wobei n = 1, 2, 3, ... ist, und
- eine Zahlenzustandsauswahleinrichtung (40), die zum Auswählen von Teilpulsen (4, 4A), die mindestens einen Satz vorbestimmter Elektronenzahlzustände aufweisen, als den zu erzeugenden gepulsten Elektronenstrahl (1) angeordnet ist.

2. Elektronenstrahlvorrichtung nach Anspruch 1, wobei

- die Photoemissionselektronenquelle (21) zum Erzeugen von zählbaren niedriggeladenen Elektronenpulsen, vorzugsweise aufweisend 1, 2, 3 oder 4 Elektronen pro Puls, ausgebildet ist.

3. Elektronenstrahlvorrichtung nach einem der vorherigen Ansprüche, wobei

- die Photoemissionselektronenquelle (21) eine strahlbegrenzende Apertur (20A) umfasst, die zum Reduzieren von hochgeladenen Elektronenpulsen zu zählbaren niedriggeladenen Elektronenpulsen eingerichtet ist.

4. Elektronenstrahlvorrichtung nach einem der vorherigen Ansprüche, wobei

- die Photoemissionselektronenquelle (21) zum Erzeugen von Mehrelektronenzuständen mit zusätzlich zu der Pulsladung unterscheidbaren Eigenschaften ausgebildet ist.

5. Elektronenstrahlvorrichtung nach einem der vorherigen Ansprüche, wobei die Zahlenzustandsdispersionseinrichtung (30) eine energiedispersive Einrichtung umfasst.

6. Elektronenstrahlvorrichtung nach Anspruch 5, wobei die energiedispersive Einrichtung umfasst

- einen Strahlmonochromator, insbesondere einen Strahlmonochromator vom Omega-Typ, Alpha-Typ, Wien-Filter-Typ, Doppel-Wien-Typ oder Elektronenspiegel-Typ.

7. Elektronenstrahlvorrichtung nach Anspruch 5, wobei die energiedispersive Einrichtung umfasst

- eine Spektrometereinrichtung, insbesondere eine Spektrometereinrichtung mit einem magnetischen Prisma oder einer elektrostatischen Multipolelektronenoptik.

8. Elektronenstrahlvorrichtung nach einem der vorherigen Ansprüche, wobei die Zahlenzustandsdispersionseinrichtung (30) eine Impulsdispersionseinrichtung oder eine Positionsdispersionseinrichtung oder eine Elektronenorbitalimpulsdispersionseinrichtung, insbesondere mindestens eine rotationssymmetrische Elektronenlinse oder eine zylindrische Elektronenlinse, umfasst.

9. Elektronenstrahlvorrichtung nach einem der vorherigen Ansprüche, wobei die Zahlenzustandsdispersionseinrichtung (30) eine Elektronenspindispersionseinrichtung umfasst.

10. Elektronenstrahlvorrichtung nach einem der vorherigen Ansprüche, wobei

    - die Zahlenzustandsauswahleinrichtung (40) einen räumlichen Modulator der Elektronenstrahlintensität umfasst, der insbesondere dazu ausgebildet ist, die ausgewählten Teilpulse (4, 4A) mit dem vorbestimmten Elektronenzahlzustand durchzulassen und die übrigen Teilpulse (4, 4A) zu blockieren.

11. Elektronenstrahlvorrichtung nach einem der vorherigen Ansprüche, wobei

    - die Zahlenzustandsauswahleinrichtung (40) mindestens eines umfasst von: einen mechanischen Schlitz, ein Gitter, einen linearen Strahlblock, ein Loch, einen Ring oder eine Scheibe.

12. Elektronenstrahlvorrichtung nach einem der vorherigen Ansprüche, ferner aufweisend

    - eine Detektoreinrichtung, die zum Bestimmen einer Anzahl von Elektronen in mindestens einem der Elektronenzahlzustände des gepulsten Elektronenstrahls (1) eingerichtet ist, und

13. Elektronenstrahlvorrichtung nach einem der vorherigen Ansprüche, ferner aufweisend

    - eine strahlformende Elektronenoptik, die zum Beleuchten einer Probe, wie einer zu untersuchenden Probe, und/oder eines Werkstücks, wie eines Halbleiterwerkstücks, ausgebildet ist.

14. Elektronenstrahlvorrichtung nach einem der vorherigen Ansprüche, wobei

    - die Photoemissionselektronenquelle (21) eine spitzenförmige Photoemissionselektronenquelle umfasst.

15. Elektronenmikroskopvorrichtung, ausgestattet mit der Elektronenstrahlvorrichtung nach einem der vorherigen Ansprüche.

16. Verfahren zum Erzeugen eines gepulsten Elektronenstrahls (1), der eine Folge von Elektronenpulsen umfasst, aufweisend die Schritte

    - Erzeugen einer Folge von Emitteranregungspulsen (2), insbesondere von Laserpulsen, mit einer Strahlungsquelleneinrichtung (10),
    - Bestrahlen einer Photoemissionselektronenquelle (21) einer Elektronenquelleneinrichtung (20) mit den Emitteranregungspulsen (2), so dass durch strahlungsinduzierte Emission Quellenelektronenpulse (3) erzeugt werden,
    - räumliches Trennen der Quellelektronenpulse (3) in Teilpulse (4, 4A), wobei jeder Teilpuls (4, 4A) eine ganzzahlige Elektronenzahl (n) umfasst, mit n = 1, 2, 3, ..., mit einer Zahlenzustandsdispersionseinrichtung (30), und
    - Auswählen von Teilpulsen (4, 4A), die mindestens einen Satz vorbestimmter Elektronenzahlzustände aufweisen, als den zu erzeugenden gepulsten Elektronenstrahl (1) mit einer Zahlenzustandsauswahleinrichtung (40).

17. Verfahren nach Anspruch 16, aufweisend den Schritt

    - Einstellen der Strahlungsquelleneinrichtung (10) und/oder der Photoemissionselektronenquelle (21) zum Erzeugen von Mehrelektronenzuständen, die neben der Pulsladung durch eine Eigenschaft unterscheidbar sind.

18. Verfahren nach einem der Ansprüche 16 bis 17, aufweisend den Schritt

    - Anpassen der Zahlenzustandsdispersionseinrichtung (30) gemäß einer unterscheidbaren Eigenschaft der Quellelektronenpulse (3), insbesondere einer Energie, eines Winkels/Impulses, eines räumlichen Fokus.

19. Verfahren nach einem der Ansprüche 16 bis 18, aufweisend den Schritt

    - Anpassen der Zahlenzustandsauswahleinrichtung zum Zurückweisen oder Blockieren bestimmter Zahlenzustände aus dem Strahl, insbesondere zum Zurückweisen oder Blockieren aller n > 2 oder zum Zurückweisen oder Blockieren aller Teilpulse (4, 4A) mit $n \neq 2$.

20. Verfahren nach einem der Ansprüche 16 bis 19, aufweisend den Schritt

- Anpassen der Strahlungsquelleneinrichtung (10), der Photoemissionselektronenquelle (21), der Zahlenzustandsdispersionseinrichtung (30) und/oder der Zahlenzustandsauswahleinrichtung (40) basierend auf einem Ausgang eines zusätzlichen zahlenzustandsempfindlichen Detektors.

21. Verfahren zur Verwendung der Elektronenstrahlvorrichtung nach einem der Ansprüche 1 bis 15 als Strahlenquelle in mindestens einer der folgenden Vorrichtungen: einer Elektronenmikroskopievorrichtung, einer Elektronenlithographievorrichtung, einer Elektronenpaar(quellen)vorrichtung, einer Elektronen-Heralding-Vorrichtung, einer Elektronenzählvorrichtung, einer Informationsverarbeitungsvorrichtung, einer Kommunikationsvorrichtung und einer Quantencomputervorrichtung.

**Revendications**

1. Appareil à faisceau d'électrons (100), configuré pour générer un faisceau d'électrons pulsé (1), comprenant une séquence d'impulsions d'électrons, comprenant

    - un dispositif de source de rayonnement (10) étant agencé pour créer une séquence d'impulsions d'excitation d'émetteur (2), en particulier d'impulsions laser,
    - un dispositif de source d'électrons (20) ayant une source d'électrons de photoémission (21), qui est agencé pour l'émission induite par rayonnement d'impulsions d'électrons de source (3) en réponse à une irradiation avec les impulsions d'excitation d'émetteur (2),
    - un dispositif de dispersion d'état de nombre (30) agencé pour séparer spatialement les impulsions d'électrons de source (3) en sous-impulsions (4, 4A), dans lequel chaque sous-impulsion (4, 4A) comporte un nombre d'électrons entier (n), avec n = 1, 2, 3..., et
    - un dispositif de sélection d'état de nombre (40) agencé pour sélectionner des sous-impulsions (4, 4A) comprenant au moins un ensemble d'états de nombre d'électrons prédéterminés comme le faisceau d'électrons pulsé (1) à générer.

2. Appareil à faisceau d'électrons selon la revendication 1, dans lequel

    - la source d'électrons de photoémission (21) est configurée pour générer des impulsions d'électrons à faible charge dénombrables, de préférence comportant 1, 2, 3 ou 4 électrons par impulsion.

3. Appareil à faisceau d'électrons selon l'une des revendications précédentes, dans lequel

    - la source d'électrons de photoémission (21) comprend une ouverture de limitation de faisceau (20A) configurée pour réduire les impulsions d'électrons à haute charge en impulsions d'électrons à faible charge dénombrables.

4. Appareil à faisceau d'électrons selon l'une des revendications précédentes,

    - la source d'électrons de photoémission (21) est configurée pour générer des états multi-électrons avec des propriétés distinguables en plus de la charge d'impulsion.

5. Appareil à faisceau d'électrons selon l'une des revendications précédentes, dans lequel le dispositif de dispersion d'état de nombre (30) comprend un dispositif dispersif en énergie.

6. Appareil de microscopie électronique selon la revendication 5, dans lequel le dispositif dispersif en énergie comprend

    - un monochromateur à faisceau, en particulier un monochromateur à faisceau de type oméga, de type alpha, de type à filtre de Wien, de type à double filtre de Wien ou de type à miroir électronique.

7. Appareil de microscopie électronique selon la revendication 5, dans lequel le dispositif dispersif en énergie comprend

    - un dispositif de spectromètre, en particulier un dispositif de spectromètre comprenant un prisme magnétique ou une optique électronique électrostatique multipolaire.

8. Appareil à faisceau d'électrons selon l'une des revendications précédentes, dans lequel le dispositif de dispersion d'état de nombre (30) comprend un dispositif de dispersion de moment ou un dispositif de dispersion de position ou un dispositif de dispersion de moment orbital d'électrons, en particulier au moins l'une d'une lentille électronique symétrique en rotation et d'une lentille électronique cylindrique.

9. Appareil à faisceau d'électrons selon l'une des revendications précédentes, dans lequel le dispositif de dispersion d'état de nombre (30) comprend un dispositif de dispersion de spin d'électron.

10. Appareil à faisceau d'électrons selon l'une des revendications précédentes, dans lequel

- le dispositif de sélection d'état de nombre (40) comprend un modulateur spatial de l'intensité du faisceau d'électrons, en particulier configuré pour faire passer les sous-impulsions (4, 4A) sélectionnées avec l'état de nombre d'électrons prédéterminé et bloquer les sous-impulsions (4, 4A) restantes.

11. Appareil à faisceau d'électrons selon l'une des revendications précédentes, dans lequel

   - le dispositif de sélection d'état de nombre (40) comprend au moins l'un d'une fente mécanique, d'une grille, d'un bloc de faisceau linéaire, d'un trou, d'une bague ou d'un disque.

12. Appareil à faisceau d'électrons selon l'une des revendications précédentes, comprenant en outre

   - un dispositif de détecteur configuré pour déterminer un nombre d'électrons au sein d'au moins un des états de nombre d'électrons du faisceau d'électrons pulsé (1), et

13. Appareil à faisceau d'électrons selon l'une des revendications précédentes, comprenant en outre

   - une optique électronique de formation de faisceau configurée pour éclairer un échantillon, comme un échantillon à examiner et/ou une pièce à usiner, comme une pièce à usiner semi-conductrice.

14. Appareil à faisceau d'électrons selon l'une des revendications précédentes, dans lequel

   - la source d'électrons de photoémission (21) comprend une source d'électrons de photoémission en forme de pointe.

15. Appareil de microscopie électronique pourvu de l'appareil à faisceau d'électrons selon l'une des revendications précédentes.

16. Procédé de génération d'un faisceau d'électrons pulsé (1), comprenant une séquence d'impulsions d'électrons, comprenant les étapes

   - de création d'une séquence d'impulsions d'excitation d'émetteur (2), en particulier d'impulsions laser, avec un dispositif de source de rayonnement (10),
   - d'irradiation d'une source d'électrons de photoémission (21) d'un dispositif de source d'électrons (20) avec les impulsions d'excitation d'émetteur (2), de sorte que des impulsions d'électrons de source (3) soient créées par émission induite par rayonnement,

   - de séparation spatiale des impulsions d'électrons de source (3) en sous-impulsions (4, 4A), dans lequel chaque sous-impulsion (4, 4A) comporte un nombre d'électrons entier (n), avec n = 1, 2, 3..., avec un dispositif de dispersion d'état de nombre (30), et
   - de sélection de sous-impulsions (4, 4A) comprenant au moins un ensemble d'états de nombre d'électrons prédéterminés comme faisceau d'électrons pulsé (1) à générer, avec un dispositif de sélection d'état de nombre (40).

17. Procédé selon la revendication 16, comportant l'étape de

   - réglage du dispositif de source de rayonnement (10) et/ou de la source d'électrons de photoémission (21) pour générer des états multi-électrons, qui sont distinguables par une propriété en plus de la charge d'impulsion.

18. Procédé selon l'une des revendications 16 à 17, comportant l'étape de

   - réglage du dispositif de dispersion d'état de nombre (30) selon une propriété distinguable des impulsions d'électrons de source (3), en particulier une énergie, un angle/moment, une focalisation spatiale.

19. Procédé selon l'une des revendications 16 à 18, comportant l'étape de

   - réglage du dispositif de sélection d'état de nombre pour rejeter ou bloquer des états de nombre spécifiques du faisceau, intéressant notamment pour rejeter ou bloquer toutes les n>2 ou pour rejeter ou bloquer toutes les sous-impulsions (4, 4A) avec n ≠ 2.

20. Procédé selon l'une des revendications 16 à 19, comportant l'étape de

   - réglage du dispositif de source de rayonnement (10), de la source d'électrons de photoémission (21), du dispositif de dispersion d'état de nombre (30) et/ou du dispositif de sélection d'état de nombre (40) sur la base d'une sortie d'un détecteur sensible à l'état de nombre supplémentaire.

21. Procédé d'utilisation de l'appareil à faisceau d'électrons selon l'une des revendications 1 à 15 comme source de faisceau dans au moins l'un d'un appareil de microscopie électronique, d'un appareil de lithographie électronique, d'un appareil (de source) de paires d'électrons, d'un appareil d'annonce électronique, d'un appareil de comptage d'électrons, d'un appareil de traitement de l'information, d'un appareil de communication et d'un appareil de calcul quantique.

FIG. 1

FIG. 2

FIG. 3

FIG. 4

FIG. 5

FIG. 6

FIG. 7

FIG. 8

FIG. 9

EP 4 526 915 B1

FIG. 10

26

FIG. 11 (A – D)

FIG. 11 (E – H)

FIG. 12

FIG. 13 (A - B)

FIG. 13 (C - D)

FIG. 13 (E - F)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **D. N. KLYSHKO**. *Phys.-Usp*, 1996, vol. 39, 573
- **M. I. KOLOBOV**. *Rev. Mod. Phys*, 1999, vol. 71, 1539
- **G. KOTLIAR** ; **D. VOLLHARDT**. *Physics Today*, 2004, vol. 57, 53
- **E. MOROSAN** ; **D. NATELSON** ; **A. H. NEVIDOMS-KYY** ; **Q. SI**. *Adv. Mater.*, 2012, vol. 24, 4896
- **T. D. LADD** ; **F. JELEZKO** ; **R. LAFLAMME** ; **Y. NAKAMURA** ; **C. MONROE** ; **J. L. O'BRIEN**. *Nature*, 2010, vol. 464, 45
- **O. KFIR** ; **V. DI GIULIO** ; **F. J. G. DE ABAJO** ; **C. ROPERS**. *Sci. Adv*, 2021, vol. 7, eabf6380
- **S. ASBAN** ; **F. J. GARCIA DE ABAJO**. *npj Quantum Inf*, 2021, vol. 7, 42
- **V. DI GIULIO** ; **M. KOCIAK** ; **F. J. G. DE ABAJO**. *Optica*, 2019, vol. 6, 1524
- **A. E. TURNER** ; **C. W. JOHNSON** ; **P. KRUIT** ; **B. J. MCMORRAN**. *Phys. Rev. Lett.*, 2021, vol. 127, 110401
- **P. KRUIT** ; **R. HOBBS** ; **C.-S. KIM** ; **Y. YANG** ; **V. MANFRINATO** ; **J. HAMMER** ; **S. THOMAS** ; **P. WEBER** ; **B. KLOPFER** ; **C. KOHSTALL**. *Ultra-microscopy*, 2016, vol. 164, 31
- **T. JUFFMANN** ; **S. A. KOPPELL** ; **B. B. KLOPFER** ; **C. OPHUS** ; **R. M. GLAESER** ; **M. A. KASEVICH**. *Sci. Rep*, 2017, vol. 7, 1699
- **E. ROTUNNO** ; **S. GARGIULO** ; **G. M. VANACORE** ; **C. MECHEL** ; **A. TAVABI** ; **R. E. D. BORKOWSKI** ; **F. CARBONE** ; **I. MAIDAN** ; **M. ZANFROGNINI** ; **S. FRABBONI**. *arXiv:2106.08955*, 2021
- **O. KFIR**. *Phys. Rev. Lett.*, 2019, vol. 123, 103602
- **V. DI GIULIO** ; **O. KFIR** ; **C. ROPERS** ; **F. J. GARCIA DE ABAJO**. *ACS Nano*, 2021, vol. 15, 7290
- **A. FEIST** ; **G. HUANG** ; **G. AREND** ; **Y. YANG** ; **J.-W. HENKE** ; **A. S. RAJA** ; **F. J. KAPPERT** ; **R. N. WANG** ; **H. LOURENÇO-MARTINS** ; **Z. QIU**. *Science*, 2022, vol. 377, 777
- **M. LEIJNSE** ; **M. R.WEGEWIJS** ; **M. H. HETTLER**. *Phys. Rev. Lett*, 2009, vol. 103, 156803
- **B. HENSEN** ; **H. BERNIEN** ; **A. E. DRÉAU** ; **A. REISERER** ; **N. KALB** ; **M. S. BLOK** ; **J. RUITEN-BERG** ; **R. F. L. VERMEULEN** ; **R. N. SCHOUTEN** ; **C. ABELLÁN**. *Nature*, 2015, vol. 526, 682
- **A. KONECNÁ** ; **F. LYIKANAT** ; **F. J. G. DE ABAJO**. *ArXiv220200604 Quant-Ph*, 2022
- **H. KIESEL** ; **A. RENZ** ; **F. HASSELBACH**. *Nature*, 2002, vol. 418, 392
- **M. MUÑOZ-NAVIA** ; **C. WINKLER** ; **R. PATEL** ; **M. BIRKE** ; **F. O. SCHUMANN** ; **J. KIRSCHNER**. *J. Phys.: Condens. Matter*, 2009, vol. 21, 355003
- **A. TRÜTZSCHLER** ; **M. HUTH** ; **C.-T. CHIANG** ; **R. KAMRLA** ; **F. O. SCHUMANN** ; **J. KIRSCHNER** ; **W. WIDDRA**. *Phys. Rev. Lett.*, 2017, vol. 118, 136401
- **S. LAROCHELLE** ; **A. TALEBPOUR** ; **S. L. CHIN**. *J. Phys. B: At. Mol. Opt. Phys.*, 1998, vol. 31, 1201
- **W. BECKER** ; **X. LIU** ; **P. J. HO** ; **J. H. EBERLY**. *Rev. Mod. Phys.*, 2012, vol. 84, 1011
- **M. KUWAHARA** ; **Y. YOSHIDA** ; **W. NAGATA** ; **K. NAKAKURA** ; **M. FURUI** ; **ISHIDA** ; **K. SAITOH** ; **T. UJIHARA** ; **N. TANAKA**. *Phys. Rev. Lett*, 2021, vol. 126, 125501
- **S. KERAMATI** ; **W. BRUNNER** ; **T. J. GAY** ; **H. BATELAAN**. *Phys. Rev. Lett.*, 2021, vol. 127, 180602
- **T. KODAMA** ; **N. OSAKABE**. *Microscopy*, 2019, vol. 68, 133
- **M. KUWAHARA** ; **Y. NAMBO** ; **K. AOKI** ; **K. SAMESHIMA** ; **X. JIN** ; **T. UJIHARA** ; **H. ASANO** ; **K. SAITOH** ; **Y. TAKEDA** ; **N. TANAKA**. *Appl. Phys. Lett.*, 2016, vol. 109, 013108
- **K. LOEFFLER**. *Z. Angew. Phys.*, 1969, vol. 27, 145
- **G. JANSEN**. Nuclear Instruments and Methods in Physics Research Section A: Accelerators, Spectrometers. *Detectors and Associated Equipment*, 1990, vol. 298, 496
- **N. BACH** ; **T. DOMRÖSE** ; **A. FEIST** ; **T. RITTMANN** ; **S. STRAUCH** ; **C. ROPERS** ; **S. SCHÄFER**. *Struct. Dyn*, 2019, vol. 6, 014301
- **P. EMMA** ; **Z. HUANG** ; **K.-J. KIM** ; **P. PIOT**. *Phys. Rev. ST Accel. Beams*, 2006, vol. 9, 100702
- **R. DÖRNER** ; **V. MERGEL** ; **O. JAGUTZKI** ; **L. SPIELBERGER** ; **J. ULLRICH** ; **R. MOSHAMMER** ; **H. SCHMIDT-BÖCKING**. *Physics Reports*, 2000, vol. 330, 95
- **J. ULLRICH** ; **R. MOSHAMMER** ; **A. DORN** ; **R. DÖRNER** ; **L. P. H. SCHMIDT** ; **H. SCHMIDT-BÖCKING**. *Rep. Prog. Phys*, 2003, vol. 66, 1463
- **G. VAN RIESSEN** ; **Z. WEI** ; **R. S. DHAKA** ; **C. WINKLER** ; **F. O. SCHUMANN** ; **J. KIRSCHNER**. *J. Phys.: Condens. Matter*, 2010, vol. 22, 092201
- **T. DANZ** ; **T. DOMRÖSE** ; **C. ROPERS**. *Science*, 2021, vol. 371, 371

- **N. RUBIANO DA SILVA** ; **M. MÖLLER** ; **A. FEIST** ; **H. ULRICHS** ; **C. ROPERS** ; **S. SCHÄFER**. *Phys. Rev.*, 2018, vol. X, 031052
- **A. FEIST** ; **N. RUBIANO DA SILVA** ; **W. LIANG** ; **C. ROPERS** ; **S. SCHÄFER**. *Struct. Dyn*, 2018, vol. 5, 014302
- **N. BACH** ; **A. FEIST** ; **M. MÖLLER** ; **C. ROPERS** ; **S. SCHÄFER**. *Struct. Dyn. 10.1063/4.0000144*, 2022
- **T. R. HARVEY** ; **J.-W. HENKE** ; **O. KFIR** ; **H. LOURENGO-MARTINS** ; **A. FEIST** ; **F. J. GARCIA DE ABAJO** ; **C. ROPERS**. *Nano Lett.*, 2020, vol. 20, 4377
- **O. KFIR** ; **H. LOURENGO-MARTINS** ; **G. STORECK** ; **M. SIVIS** ; **T. R. HARVEY** ; **T. J. KIPPENBERG** ; **A. FEIS** ; **C. ROPERS**. *Nature*, 2020, vol. 582, 46
- **J.-W. HENKE** ; **A. S. RAJA** ; **A. FEIST** ; **G. HUANG** ; **G. AREND** ; **Y. YANG** ; **F. J. KAPPERT** ; **R. N. WANG** ; **M. MÖLLER** ; **J. PAN**. *Nature*, 2021, vol. 600, 653
- **M. LIEBTRAU** ; **M. SIVIS** ; **A. FEIST** ; **H. LOUR-ENGO-MARTINS** ; **N. PAZOS-PÉREZ** ; **R. A. ALVAREZ-PUEBLA** ; **F. J. GARCIA DE ABAJO** ; **A. POLMAN** ; **C. ROPERS**. *Light Sci Appl*, 2021, vol. 10, 82
- **D. JANNIS** ; **C. HOFER** ; **C. GAO** ; **X. XIE** ; **A. BÉCHÉ** ; **T. PENNYCOOK** ; **J. VERBEECK**. *Ultramicroscopy*, 2022, vol. 233, 113423
- **Y. AUAD** ; **M. WALLS** ; **J.-D. BLAZIT** ; **O. STÉPHAN** ; **L. H. TIZEI** ; **M. KOCIAK** ; **F. DE LA PEÑA** ; **M. TENCÉ**. *Ultramicroscopy*, 2022, 113539
- **D. JANNIS** ; **K. MÜLLER-CASPARY** ; **A. BÉCHÉ** ; **A. OELSNER** ; **J. VERBEECK**. *Appl. Phys. Lett.*, 2019, vol. 114, 143101
- **N. VARKENTINA** ; **Y. AUAD** ; **S. Y. WOO** ; **A. ZOBELLI** ; **J.-D. BLAZIT** ; **X. LI** ; **M. TENCÉ** ; **K. WATANABE** ; **T. TANIGUCHI** ; **O. STÉPHAN**. *arXiv:2202.12520*, 2022
- **A. FEIST** ; **N. BACH** ; **N. RUBIANO DA SILV** ; **T. DANZ** ; **M. MÖLLER** ; **K. E. PRIEBE** ; **T. DOMRÖSE** ; **J. G. GATZMANN** ; **S. ROST** ; **J. SCHAUSS**. *Ultramicroscopy*, 2017, vol. 176, 63
- **B. COOK** ; **M. BRONSGEEST** ; **K. HAGEN** ; **P. KRUIT**. *Ultramicroscopy*, 2009, vol. 109, 403
- **J. SCHÖTZ** ; **L. SEIFFERT** ; **A. MALIAKKA** ; **J. BLÖCHL** ; **D. ZIMIN** ; **P. ROSENBERGER** ; **B. BERGUES** ; **P. HOMMELHOFF** ; **F. KRAUSZ** ; **T. FENNEL**. *Nanophotonics*, 2021, vol. 10, 3769
- **M. BRONSGEEST**. Physics of Schottky Electron Sources: Theory and Optimum Operation. Pan Stanford Publications, 2014
- **T. KODAMA** ; **N. OSAKABE** ; **A. TONOMURA**. *Phys. Rev. A*, 2011, vol. 83, 063616
- **G. BAYM** ; **K. SHEN**. *ArXiv12124008 Cond-Mat Physicsquant-Ph*, 2012
- **D. N. FITTINGHOFF** ; **P. R. BOLTON** ; **B. CHANG** ; **K. C. KULANDER**. *Phys. Rev. Lett.*, 1992, vol. 69, 2642
- **R. HERRMANN** ; **S. SAMARIN** ; **H. SCHWABE** ; **J. KIRSCHNER**. *Phys. Rev. Lett.*, 1998, vol. 81, 2148
- **S. A. SHEINERMAN** ; **V. SCHMIDT**. *J. Phys. B: At. Mol. Opt. Phys.*, 1997, vol. 30, 1677
- **S. MEIER** ; **P. HOMMELHOFF**. *ACS Photonics, acsphotonics*, 2022, 2c00839
- **O. L. KRIVANEK** ; **J. P. URSIN** ; **N. J. BACON** ; **G. J. CORBIN** ; **N. DELLBY** ; **P. HRNCIRIK** ; **M. F. MURFITT** ; **C. S. OWN** ; **Z. S. SZILAGYI**. *Phil. Trans. R. Soc. A.*, 2009, vol. 367, 3683
- **VAN SCHAYCK** ; **J. PAUL**. M4I-nanoscopy/tpx3Hit-Parser: Create-cluster_stats option for storing sum-ToT and nHits. *Zenodo*, 2021
- **J. P. VAN SCHAYCK** ; **E. VAN GENDEREN** ; **E. MADDOX** ; **L. ROUSSEL** ; **H. BOULANGER** ; **E. FRÖJDH** ; **J.-P. ABRAHAMS** ; **P. J. PETERS** ; **R. B. RAVELLI**. *Ultramicroscopy*, 2020, vol. 218, 113091
- **R. F. EGERTON**. Electron energy-loss spectroscopy in the TEM. *Reports on Progress in Physics*, 2009, vol. 72
- **O. L. KRIVANEK** ; **A. J. GUBBENS** ; **N. DELLBY** ; **C. E. MEYER**. Design and first applications of a post-column imaging filter.. *Microscopy Microanalysis Microstructures.*, 1992, vol. 3, 187-199
- Test and characterization of a new post-column imaging energy filter. **F. KAHL** ; **V. GERHEIM** ; **M. LINCK** ; **M. HEIKO** ; **S. UHLEMANN** ; **H. MÜLLER** ; **R. SCHILLINGER** ; **S. UHLEMANN**. Advances in Imaging and Electron Physics. Elsevier Inc, 2019, vol. 212, 35-70
- **K. KIMOTO**. Practical aspects of monochromators developed for transmission electron microscopy.. *Microscopy (Tokyo).*, 2014, vol. 63, 337-344